# EUROPEAN PATENT APPLICATION

(11) **EP 4 672 936 A1**
(43) Date of publication of application: **31.12.2025**
(21) Application number: 25184381.9
(22) Date of filing: 23.06.2025
(51) Int. Cl.: H10K 59/12, H10K 77/10, H10K 102/00

(54) **DISPLAY DEVICE**

(30) Priority: 26.06.2024 KR 20240083734; 26.07.2024 KR 20240099617
(71) Applicant: Samsung Display Co., Ltd., Yongin-si, Gyeonggi-do 17113 (KR)
(72) Inventor: JUNG, Wu Hyeon, Yongin-si, Gyeonggi-do (KR); KIM, Kyoung Duck, Yongin-si, Gyeonggi-do (KR); LIM, Seung Jin, Yongin-si, Gyeonggi-do (KR); JANG, Yong Seong, Yongin-si, Gyeonggi-do (KR)
(74) Representative: Gulde & Partner

(57) **Abstract**

A display device includes a display panel, a metal plate disposed under the display panel and a plurality of grooves formed in at least a portion of an edge of the metal plate and penetrating through at least a portion of the metal plate. The display panel includes a substrate, a circuit layer and an element layer. The substrate includes a main area including a flat display area and a curved area disposed around the flat display area. The curved area includes a peripheral display area disposed around the flat display area, and a non-display area disposed between an edge of the main area and the peripheral display area. Light emitting areas are disposed in the flat display area and the peripheral surrounding display area and the element layer includes light emitting elements respectively disposed in the light emitting areas.

## Description

### BACKGROUND

### 1. Technical Field

The present disclosure relates to a display device.

### 2. Description of the Related Art

As an information society develops, the demand for a display device for displaying an image is increasing in various forms. For example, the display device has been applied to various electronic devices such as smartphones, digital cameras, laptop computers, navigation devices, and smart televisions.

The display device may be a flat panel display device such as a liquid crystal display device, a field emission display device, or a light emitting display device. The light emitting display device may include an organic light emitting display device including an organic light emitting element, an inorganic light emitting display device including an inorganic light emitting element such as an inorganic semiconductor, and a micro or nano light emitting display device including a micro or nano light emitting element.

The organic light emitting display device displays an image using light emitting elements where each light emitting element includes a light emitting layer made of an organic light emitting material. As such, as the organic light emitting display device implements an image display using self-light emitting elements, the organic light emitting display device may have relatively superior performance in terms of power consumption, response speed, emission efficiency, luminance, and wide viewing angle compared to other display devices.

### SUMMARY

When the display area on the display surface of the display device is disposed to be wider, the area where light is emitted in the display device becomes wider. As a result, aesthetics may be improved and compatibility with various electronic devices may be improved.

However, since there are lines and elements that are necessarily disposed in the non-display area, there is a limit in reducing the width of the non-display area.

Aspects of the invention provide a display device in which a width of a non-display area viewed from a front direction facing a display surface may be reduced by deforming an edge of a display area into a curved shape while providing and/or improving a desired display quality.

Aspects of the invention are not restricted to those set forth herein. The above and other aspects of the invention will become more apparent to one of ordinary skill in the art to which the invention pertains by referencing the detailed description of the invention given below.

According to an aspect of the invention, there is provided a display device which includes a display panel emitting light for displaying an image, a metal plate disposed under the display panel and supporting the display panel and a plurality of grooves formed in at least a portion of an edge of the metal plate and penetrating through at least a portion of the metal plate. The display panel includes a substrate, a circuit layer disposed on the substrate and an element layer disposed on the circuit layer. The substrate includes a main area including a flat display area having a flat shape and a curved area disposed around the flat display area and having a curved shape. The curved area includes a peripheral display area disposed around the flat display area, and a non-display area disposed between an edge of the main area and the peripheral display area. Light emitting areas are disposed in the flat display area and the peripheral surrounding display area. The element layer includes light emitting elements disposed in the light emitting areas.

In an embodiment, the metal plate includes the main area. The edge of the main area includes a first side and a second side extending in a first direction and opposing each other in a second direction intersecting the first direction, a third side and a fourth side extending in the second direction and opposing each other in the first direction and corners connecting one of the first side and the second side and one of the third side and the fourth side. The plurality of grooves include first grooves formed in a portion of the curved area, disposed adjacent to at least one of the corners, and spaced apart from the edge of the main area.

In an embodiment, the flat display area includes a fifth side and a sixth side extending in the first direction and opposing each other in the second direction and a seventh side and an eighth side extending in the second direction and opposing each other in the first direction. The curved area includes a first side area between the first side and the fifth side, a second side area between the second side and the sixth side, a third side area between the third side and the seventh side, a fourth side area between the fourth side and the eighth side, a first corner area in contact with a vertex between the fifth side and the seventh side and disposed between the first side area and the third side area, a second corner area in contact with a vertex between the sixth side and the seventh side and disposed between the second side area and the third side area, a third corner area in contact with a vertex between the sixth side and the eighth side and disposed between the second side area and the fourth side area and a fourth corner area in contact with a vertex between the fifth side and the eighth side and disposed between the first side area and the fourth side area. The first grooves are formed in at least one of the first corner area, the second corner area, the third corner area, and the fourth corner area.

In an embodiment, the first grooves are further arranged in a portion of at least one of the first side area, the second side area, the third side area, and the fourth side area.

In an embodiment, the first grooves have a polygonal or circular shape and are arranged to be directed parallel in directions intersecting each other.

In an embodiment, the first grooves have a slit shape extending in a direction intersecting the edge of the main area. A first line in which the first grooves are arranged in parallel with each other is directed parallel to the edge of the main area.

In an embodiment, the plurality of grooves further include second grooves formed in at least one of the first side area, the second side area, the third side area, and the fourth side area and having a slit shape extending in the direction intersecting the edge of the main area, where the second grooves are arranged to be directed parallel to the first grooves in the first line.

In an embodiment, the plurality of grooves further include third grooves formed in at least one of the first side area, the second side area, the third side area, and the fourth side area and disposed adjacent to the flat display area and fourth grooves formed in at least one of the first corner area, the second corner area, the third corner area, and the fourth corner area and disposed adjacent to the flat display area. The third grooves and the fourth grooves have a slit shape extending in the direction parallel to the edge of the main area.

In an embodiment, at least some of the third grooves and the fourth grooves are further formed at an edge of the flat display area.

In an embodiment, the third grooves are arranged in two or more lines, where each of the two or more lines are directed parallel to the edge of the main area. The two or more lines are spaced apart from each other by a first gap or more in the direction intersecting the edge of the main area.

In an embodiment, the two or more lines include a second line and a third line. In the direction intersecting the edge of the main area, the third groove of the second line faces the third groove of the third line.

In an embodiment, the fourth grooves are arranged to be directed parallel to the third grooves in the two or more lines.

In an embodiment, the two or more lines further include a fourth line. The third line is disposed between the second line and the fourth line. In the direction intersecting the edge of the main area, the fourth groove of the second line faces the fourth groove of the fourth line.

In an embodiment, the fourth grooves are arranged in two or more narrow lines. Each of the two or more narrow lines is directed parallel to the edge of the main area. The two or more narrow lines are spaced apart from each other by a second gap or less, which is smaller than the first gap, in the direction intersecting the edge of the main area.

In an embodiment, the two or more narrow lines include a first narrow line disposed adjacent to the edge of the main area, and a second narrow line disposed adjacent to an edge of the flat display area. The fourth groove of the second narrow line has a shorter length than the fourth groove of the first narrow line.

In an embodiment, the display device further includes second grooves formed in at least one of the first side area, the second side area, the third side area, and the fourth side area and having a slit shape extending in the direction intersecting the edge of the main area. The second grooves are arranged to be directed parallel to the first grooves in the first line.

In an embodiment, the display device further includes a cover window disposed on the display panel and coupled to the display panel through a transparent adhesive layer and a bracket disposed under the metal plate, supporting the display panel and the metal plate, and coupled to the cover window.

According to an aspect of the invention, there is provided an electronic device comprising a display device that includes a display panel emitting light for displaying an image, a metal plate disposed under the display panel and supporting the display panel, a plurality of grooves formed in at least a portion of an edge of the metal plate and penetrating through at least a portion of the metal plate, a cover window disposed on the display panel and coupled to the display panel through a transparent adhesive layer and a bracket disposed under the metal plate, supporting the display panel and the metal plate, and coupled to the cover window. The display panel includes a substrate, a circuit layer disposed on the substrate and an element layer disposed on the circuit layer. Each of the substrate and the metal plate includes a main area including a flat display area having a flat shape and a curved area disposed around the flat display area and having a curved shape. The curved area includes a peripheral display area disposed around the flat display area, and a non-display area disposed between an edge of the main area and the peripheral display area. Light emitting areas are disposed in the flat display area and the peripheral surrounding display area. The element layer includes light emitting elements disposed in the light emitting areas.

In an embodiment, the edge of the main area includes a first side and a second side extending in a first direction and opposing each other in a second direction intersecting the first direction, a third side and a fourth side extending in the second direction and opposing each other in the first direction and corners connecting one of the first side and the second side and one of the third side and the fourth side. The flat display area includes a fifth side and a sixth side extending in the first direction and opposing each other in the second direction and a seventh side and an eighth side extending in the second direction and opposing each other in the first direction. The curved area includes a first side area disposed between the first side and the fifth side, a second side area disposed between the second side and the sixth side, a third side area disposed between the third side and the seventh side, a fourth side area disposed between the fourth side and the eighth side, a first corner area in contact with a vertex between the fifth side and the seventh side and disposed between the first side area and the third side area, a second corner area in contact with a vertex between the sixth side and the seventh side and disposed between the second side area and the third side area, a third corner area in contact with a vertex between the sixth side and the eighth side and disposed between the second side area and the fourth side area and a fourth corner area in contact with a vertex between the fifth side and the eighth side and disposed between the first side area and the fourth side area. The plurality of grooves include first grooves formed in at least one of the first corner area, the second corner area, the third corner area, and the fourth corner area, disposed adjacent to at least one of the corners, arranged along the edge of the main area, and spaced apart from the edge of the main area. The first grooves have a slit shape extending in a direction intersecting the edge of the main area.

In an embodiment, the plurality of grooves further include at least one of second grooves formed in at least one of the first side area, the second side area, the third side area, and the fourth side area, third grooves formed in at least one of the first side area, the second side area, the third side area, and the fourth side area and disposed adjacent to an edge of the flat display area, and fourth grooves formed in at least one of the first corner area, the second corner area, the third corner area, and the fourth corner area and disposed adjacent to the edge of the flat display area. The second grooves have a slit shape extending in the direction intersecting the edge of the main area. The third grooves and the fourth grooves have a slit shape extending in the direction parallel to the edge of the main area.

In an embodiment, the display device may include a display panel that emits light for displaying an image, and a metal plate that is disposed under the display panel and supports the display panel.

In an embodiment, the display panel may include a substrate, a circuit layer, and an element layer.

In an embodiment, the substrate may include a main area including a display area in which light emitting areas are disposed, and a non-display area disposed around the display area.

In an embodiment, the display area may include a flat display area and a peripheral display area disposed around the flat display area and having a curved shape.

In an embodiment, in this way, as the display area includes the peripheral display area having the curved shape, the non-display area connected to the peripheral display area may have a curved shape together with the peripheral display area. That is, a width of the non-display area having the curved shape as viewed from the front direction facing the display surface may be smaller than a width of the non-display area in the unfolded state. Therefore, since a width of the display area of the display surface of the display device that is viewed from the front direction may be increased, the aesthetics and compatibility of the display device may be improved.

The display device includes a plurality of grooves formed in at least a portion of an edge of the metal plate and penetrating through at least a portion of the metal plate.

In this way, by means of the plurality of grooves, compressive stress or bending stress applied to a peripheral support area of the curved shape of the metal plate may be reduced or distributed, and a restoration defect in which the peripheral support area is deformed from the curved shape back to the flat shape due to a repulsive force of the metal plate may be reduced.

As a result, a defect in which the edge of the metal plate is distorted due to concentration of the compressive or bending stress may be prevented.

In an embodiment, since the curved shape of the peripheral support area of the metal plate may be maintained due to the reduction in the repulsive force of the metal plate, the deformation of the display panel due to the restoration defect of the metal plate may be prevented. Therefore, in a process of bonding the display panel and the cover window, a defect in which air bubbles are inserted into a transparent adhesive layer between the display panel and the cover window may be prevented. Therefore, the display quality of the display device can be improved.

However, the effects of the embodiments are not restricted to the ones set forth herein.

### BRIEF DESCRIPTION OF THE DRAWINGS

The above and other aspects and features of the invention will become more apparent by describing in detail embodiments thereof with reference to the attached drawings, in which:
FIG. 1 is a perspective view illustrating a display device, according to an embodiment;
FIG. 2 is a cross-sectional view taken along line A-A' of FIG. 1, according to an embodiment;
FIG. 3 is a cross-sectional view illustrating a display panel taken along line B-B' of FIG. 1, according to an embodiment;
FIG. 4 is a plan view illustrating a substrate of the display panel of FIG. 3, according to an embodiment;
FIG. 5 is a layout view illustrating portion C of the display panel of FIG. 3, according to an embodiment;
FIG. 6 is a layout view illustrating a touch sensor layer of the display panel of FIG. 3, according to an embodiment;
FIG. 7 is a detailed plan view illustrating portion D of FIG. 6, according to an embodiment;
FIG. 8 is an equivalent circuit diagram illustrating a light emitting pixel driver of FIG. 5, according to an embodiment;
FIG. 9 is a cross-sectional view taken along line E-E' of FIG. 7, according to an embodiment;
FIG. 10 is a plan view illustrating a metal plate of FIG. 2, according to an embodiment;
FIG. 11 is a perspective view illustrating portion F of FIG. 10 of the metal plate of FIG. 2, according to an embodiment;
FIG. 12 is a plan view illustrating portion G of FIG. 10, according to an embodiment;
FIG. 13 is an enlarged view illustrating portion H of FIG. 12, according to an embodiment;
FIG. 14 is a plan view illustrating portion G of FIG. 10, according to an embodiment;
FIG. 15 is an enlarged view illustrating portion I of FIG. 14, according to an embodiment;
FIG. 16 is a cross-sectional view taken along line I'-I" of FIG. 14, according to an embodiment;
FIG. 17 is a cross-sectional view taken along line I'-I" of FIG. 14, according to an embodiment;
FIG. 18 is a plan view illustrating portion F of FIG. 10, according to an embodiment;
FIG. 19 is a plan view illustrating portion F of FIG. 10, according to another embodiment;
FIG. 20 is an enlarged view illustrating portion J of FIG. 19, according to an embodiment;
FIG. 21 is a plan view illustrating portion F of FIG. 10, according to an embodiment;
FIG. 22 is a plan view illustrating portion F of FIG. 10, according to an embodiment;
FIG. 23 is a plan view illustrating portion F of FIG. 10, according to an embodiment; and
FIG. 24 is a plan view illustrating portion F of FIG. 10, according to an embodiment.
FIG. 25 is a block diagram of an electronic device according to an embodiment of the present disclosure.
FIG. 26 is a schematic diagram of an electronic device according to various embodiments of the present disclosure.

### DETAILED DESCRIPTION

The embodiments will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity.

Some of the parts which are not associated with the description may not be provided in order to describe embodiments of the invention.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this invention pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, embodiments will be described with reference to the accompanying drawings.

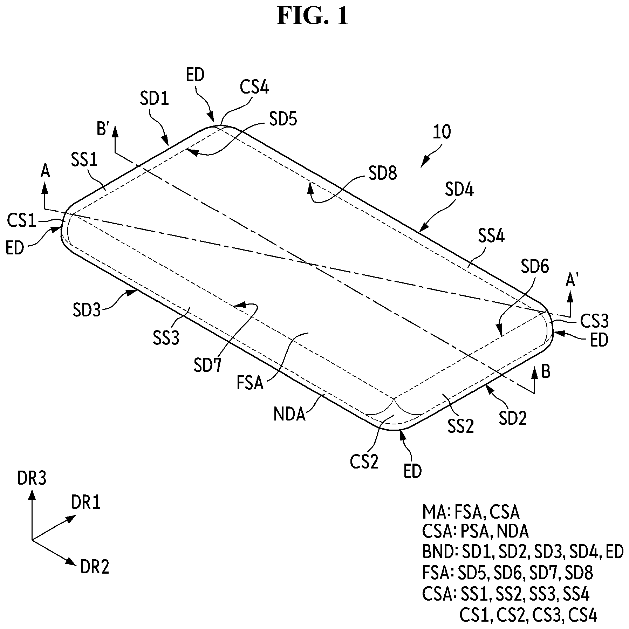

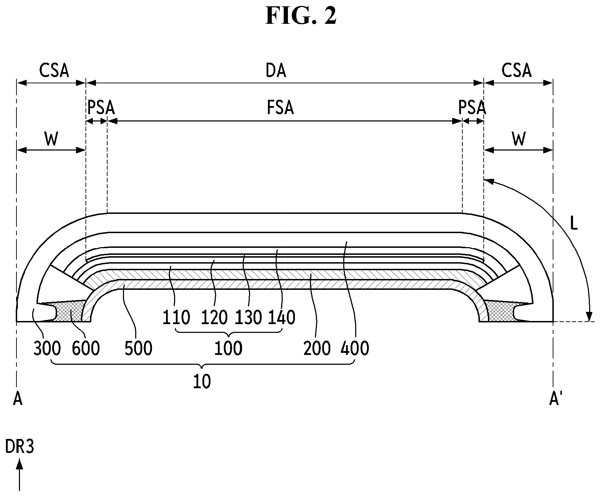

FIG. 1 is a perspective view illustrating a display device, according to an embodiment. FIG. 2 is a cross-sectional view taken along line A-A' of FIG. 1, according to an embodiment.

In an embodiment and referring to FIG. 1, a display device 10 is a device that displays a moving image or a still image, and may be used as a display screen of each of various products such as a television, a laptop computer, a monitor, a billboard, and Internet of Things (IOT) as well as portable electronic devices such as a mobile phone, a smartphone, a tablet personal computer (PC), a smartwatch, a watch phone, a mobile communication terminal, an electronic organizer, an electronic book, a portable multimedia player (PMP), a navigation device, and an ultra mobile PC (UMPC).

In another embodiment, the display device 10 may be applied to an instrument panel of a vehicle, a center fascia of a vehicle, a center information display (CID) disposed on a dashboard of a vehicle, a room mirror display substituting for a side mirror of a vehicle, or a display disposed on a rear surface of a front seat as entertainment for a rear seat of a vehicle.

In an embodiment and referring to FIG. 2, the display device 10 may include a display panel 100 that emits light for displaying an image, and a metal plate 200 that is disposed under the display panel 100 and that supports the display panel 100.

In an embodiment, the display device 10 may further include a cover window 300 disposed on the display panel 100, a transparent adhesive layer 400 disposed between the display panel 100 and the cover window 300, a bracket 500 disposed under the metal plate 200 and supporting the display panel 100 and the metal plate 200, and a sealing layer 600 disposed between the cover window 300 and the bracket 500.

In an embodiment, the display panel 100 may be a light emitting display panel including a light emitting element. For example, the display panel 100 may include an organic light emitting display panel using an organic light emitting diode including an organic light emitting layer, a micro light emitting diode (LED) display panel using a micro LED, a quantum dot light emitting display panel using a quantum dot light emitting diode including a quantum dot light emitting layer, or an inorganic light emitting display panel using an inorganic light emitting element including an inorganic semiconductor. Hereinafter, the description will be mainly made based on the fact that the display panel 100 is an organic light emitting display panel.

According to an embodiment, the display panel 100 may include a substrate 110, a circuit layer 120 disposed on the substrate 110, and an element layer 130 disposed on the circuit layer 120.

In an embodiment, the display panel 100 may further include a sealing layer 140 disposed on the element layer 130.

In an embodiment, the substrate 110 may include a main area MA including a flat display area FSA and a curved area CSA.

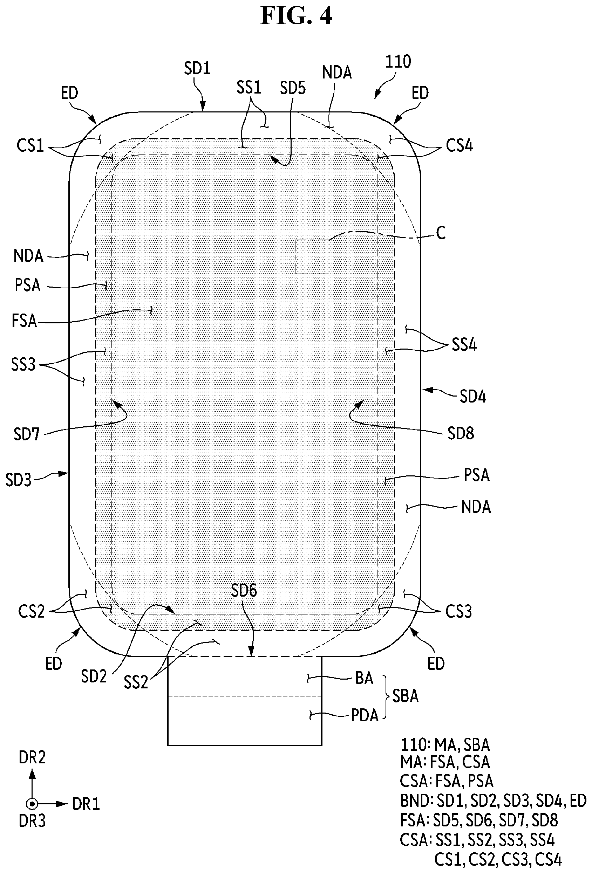

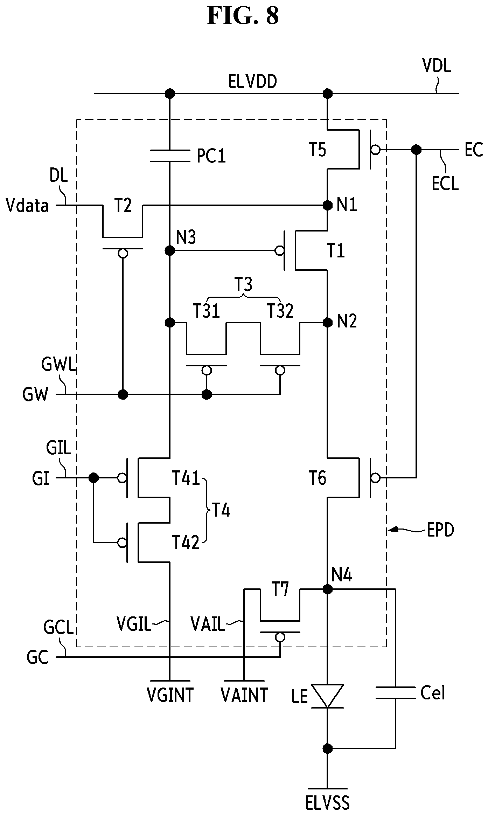

In an embodiment, the element layer 130 may include light emitting elements (LE in FIG. 8) disposed in light emitting areas (EA in FIG. 4).

In an embodiment, the circuit layer 120 may include light emitting pixel drivers (EPD in FIG. 4) that transmit a driving current to the light emitting elements LE.

In an embodiment, the sealing layer 140 may be disposed on the element layer 130 and may have a structure in which two or more inorganic films and at least one organic film are alternately stacked.

The metal plate 200 is intended to prevent deformation of the display panel 100 before it is fastened to the bracket 500.

In an embodiment, the cover window 300 may include a light transmitting material and may be made of an inorganic material such as glass or be made of an organic material such as plastic or a polymer material.

The cover window 300 may be attached to the display panel 100 through the transparent adhesive layer 400 disposed at an edge.

In an embodiment, the transparent adhesive layer 400 may be an optically clear adhesive (OCA) film or an optically clear resin (OCR).

In an embodiment and by means of the cover window 300, the display panel 100 may be protected from electrical and physical shocks on the display surface.

In an embodiment, the bracket 500 is intended to prevent deformation of the display panel 100 and to alleviate external physical and electrical shocks to the display panel 100, and may include a rigid insulating material. However, this is only an example, and the material of the bracket 500 may be changed at any time.

As illustrated in FIG. 1, according to an embodiment, one surface of the display panel 100 on which an image is displayed may include a main area MA.

As an example, in an embodiment, the main area MA may have a quadrangular shape.

In an embodiment, an edge BND of the main area MA may include a first side SD1 and a second side SD2 extending in a first direction DR1 and opposing each other in a second direction DR2, a third side SD3 and a fourth side SD4 extending in the second direction DR2 and opposing each other in the first direction DR1, and corners ED connecting two sides ED.

In an embodiment, each of the corners ED may connect one of the first side SD1 and the second side SD2 and one of the third side SD3 and the fourth side SD4.

The first side SD1 and the second side SD2 may be shorter in length than the third side SD3 and the fourth side SD4.

According to an embodiment, the main area MA may include a flat display area FSA having a flat shape, and a curved area CSA disposed around the flat display area FSA and having a curved shape.

In an embodiment, the curved area CSA may include a peripheral display area PSA disposed around the flat display area FSA, and a non-display area NDA disposed between the edge BND of the main area MA and the peripheral display area PSA.

In an embodiment, the light emitting areas (EA in FIG. 4) that emit light may be disposed in the flat display area FSA and the peripheral display area PSA. Accordingly, the flat display area FSA and the peripheral display area PSA may be collectively referred to as the display area (DA in FIG. 2).

In an embodiment, the flat display area FSA may include a fifth side SD5 and a sixth side SD6 extending in the first direction DR1 and opposing each other in the second direction DR2, and a seventh side SD7 and an eighth side SD8 extending in the second direction DR2 and opposing each other in the first direction DR1.

In an embodiment, the flat display area FSA may have a shape similar to the main area MA, that is, when the main area MA has a quadrangular shape, the fifth side SD5 and the sixth side SD6 may be shorter in length than the seventh side SD7 and the eighth side SD8.

In another embodiment, connection points where one of the fifth side SD5 and the sixth side SD6 meets one of the seventh side SD7 and the eighth side SD8 may be formed as curved arcs or right-angled vertices.

However, the shape of the flat display area FSA, according to an embodiment, is not limited to the quadrangle as illustrated in FIG. 1, and may be a polygon, circle, or ellipse other than the quadrangle.

In an embodiment, the curved area CSA may include side areas that are in contact with the sides of the flat display area FSA and corner areas that are in contact with the vertices of the flat display area FSA.

In an embodiment, the side areas may include a first side area SS1 disposed between the first side SD1 and the fifth side SD5, a second side area SS2 disposed between the second side SD2 and the sixth side SD6, a third side area SS3 disposed between the third side SD3 and the seventh side SD7, and a fourth side area SS4 disposed between the fourth side SD4 and the eighth side SD8.

In an embodiment, the corner areas may include a first corner area CS1 in contact with a vertex between the fifth side SD5 and the seventh side SD7 and disposed between the first side area SS1 and the third side area SS3, a second corner area CS2 in contact with a vertex between the sixth side SD6 and the seventh side SD7 and disposed between the second side area SS2 and the third side area SS3, a third corner area CS3 in contact with a vertex between the sixth side SD6 and the eighth side SD8 and disposed between the second side area SS2 and the fourth side area SS4, and a fourth corner area CS4 in contact with a vertex between the fifth side SD5 and the eighth side SD8 and disposed between the first side area SS1 and the fourth side area SS4.

In an embodiment, each of the first side area SS1, the second side area SS2, the third side area SS3, the fourth side area SS4, the first corner area CS1, the second corner area CS2, the third corner area CS3, and the fourth corner area CS4 may include a peripheral display area PSA and a non-display area NDA.

The first side area SS1 may have a shape that extends from the fifth side SD5 and that is curved with a first curvature radius in a direction opposite to the direction in which light is emitted.

The second side area SS2 may have a shape that extends from the sixth side SD6 and that is curved with a second curvature radius in a direction opposite to the direction in which light is emitted. The second curvature radius may be in the same range as the first curvature radius.

The third side area SS3 may have a shape that extends from the seventh side SD7 and that is curved with a third curvature radius in a direction opposite to the direction in which light is emitted. The third curvature radius may be the same as or in a similar range as the first or second curvature radius, but is not limited thereto.

The fourth side area SS4 may have a shape that extends from the eighth side SD8 and is curved with a fourth curvature radius in a direction opposite to the direction in which light is emitted. The fourth curvature radius may be in the same range as the third curvature radius.

The first corner area CS1 may be disposed between one side of the first side area SS1 and one side of the third side area SS3.

The first corner area CS1 may be a double curvature area that is curved with the first curvature radius of the first side area SS1 and the third curvature radius of the third side area SS3.

The second corner area CS2 may be disposed between one side of the second side area SS2 and one side of the third side area SS3.

The second corner area CS2 may be a double curvature area that is curved with the second curvature radius of the second side area SS2 and the third curvature radius of the third side area SS3.

The third corner area CS3 may be disposed between one side of the second side area SS2 and one side of the fourth side area SS4.

The third corner area CS3 may be a double curvature area that is curved with the second curvature radius of the second side area SS2 and the fourth curvature radius of the fourth side area SS4.

The fourth corner area CS4 may be disposed between the other side of the first side area SS1 and the other side of the fourth side area SS4.

The fourth corner area CS4 may be a double curvature area that is curved with the first curvature radius of the first side area SS1 and the fourth curvature radius of the fourth side area SS4.

In an embodiment and as illustrated in FIG. 2, the display device 10 may include a flat display area FSA having a flat shape and a curved area CSA having a curved shape.

In an embodiment, in the peripheral display area PSA of the curved area CSA disposed around the flat display area FSA, light may be emitted together with the flat display area FSA.

That is, according to an embodiment, the display area DA of the main area MA of the display device 10 from which light is emitted may further include the peripheral display area PSA having the curved shape in addition to the flat display area FSA having the flat shape.

In addition, in an embodiment, the curved area CSA having the curved shape may include a non-display area NDA from which no light is emitted. Accordingly, in the front direction facing the display device 10 (e.g., in the opposite direction to the third direction DR3), a width W of the non-display area NDA having the curved shape may be smaller than a width L of the non-display area NDA having the unfolded shape.

In an embodiment, since a proportion of the display area DA in the main area MA may increase as the width W of the non-display area NDA viewed from the front direction decreases, the aesthetics and compatibility of the display device 10 may be improved.

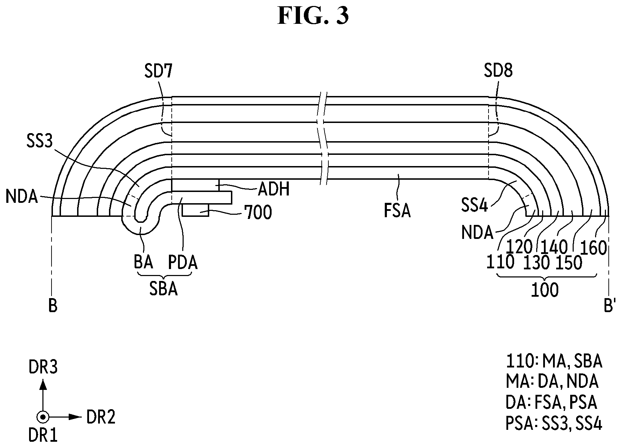

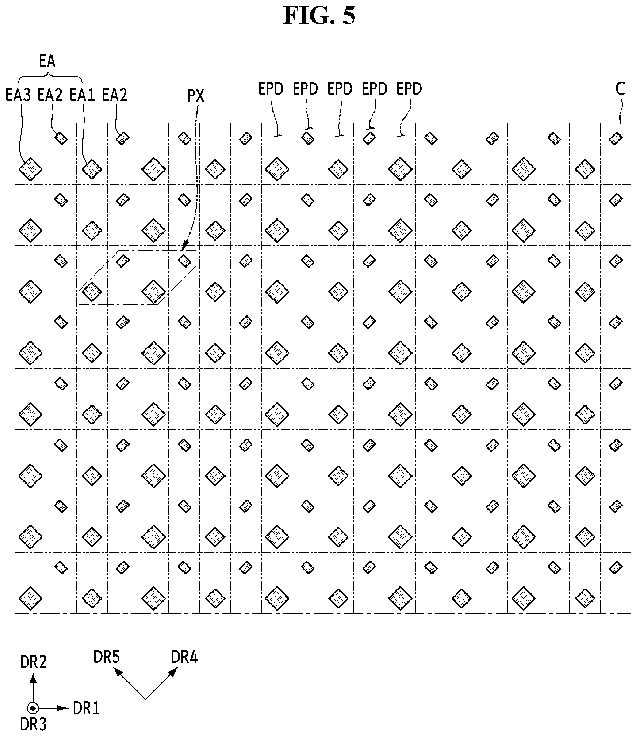

FIG. 3 is a cross-sectional view illustrating a display panel taken along line B-B' of FIG. 1, according to an embodiment. FIG. 4 is a plan view illustrating a substrate of FIG. 3, according to an embodiment. FIG. 5 is a layout view illustrating portion C of FIG. 3, according to an embodiment.

In an embodiment and referring to FIG. 3, the display panel 100 of the display device 10 may include a substrate 110, a circuit layer 120 disposed on the substrate 110, and an element layer 130 disposed on the circuit layer 120.

The substrate 110 may include a main area MA and a sub-area SBA.

The main area MA may include a display area DA and a non-display area NDA disposed around the display area DA.

The display area DA may include a flat display area FSA and a peripheral display area PSA disposed around the flat display area FSA and having a curved shape.

An edge of the flat display area FSA may include a fifth side SD5 and a sixth side SD6 facing each other in the second direction DR2.

The peripheral display area PSA may be disposed in each of the second side area SS2 in contact with the fifth side SD5 of the flat display area FSA and the second side area SS2 in contact with the sixth side SD6 of the flat display area FSA.

In an embodiment and as illustrated in FIG. 4, the edge of the flat display area FSA may further include a seventh side SD7 and an eighth side SD8 facing each other in the first direction DR1.

The peripheral display area PSA may be further disposed in each of the third side area SS3 in contact with the seventh side SD7 of the flat display area FSA and the fourth side area SS4 in contact with the eighth side SD8 of the flat display area FSA.

In an embodiment and as illustrated in FIG. 5, in the display area DA including the flat display area FSA and the peripheral display area PSA, the light emitting areas EA may be arranged in parallel with each other.

In an embodiment, the display area DA may further include a non-light emitting area disposed in a spaced portion located between the light emitting areas EA.

The light emitting areas EA may have a rhombic planar shape or a rectangular planar shape. However, this is only an example, and the planar shape of the light emitting areas EA, according to an embodiment, is not limited to that illustrated in FIG. 5. That is, the light emitting areas EA may have a polygonal planar shape such as a square, pentagon, or hexagon, or a circular or oval planar shape including curved edges.

In an embodiment, the light emitting areas EA may include first light emitting areas EA1 that emit light in a first wavelength band, second light emitting areas EA2 that emit light in a second wavelength band lower than the first wavelength band, and third light emitting areas EA3 that emit light in a third wavelength band lower than the second wavelength band.

In an embodiment, the first wavelength band is about 600 nm to about 750 nm and may be viewed as red, the second wavelength band is about 480 nm to about 560 nm and may be viewed as green and the third wavelength band is about 370 nm to about 460 nm and may be viewed as blue.

In an embodiment, the first light emitting areas EA1 and the third light emitting areas EA3 may be arranged to alternate with each other in at least one of the first direction DR1 and the second direction DR2.

In an embodiment, the second light emitting areas EA2 may be arranged to be parallel to each other in at least one of the first direction DR1 and the second direction DR2.

In an embodiment, the second light emitting areas EA2 may be disposed adjacent to the first light emitting areas EA1 and the third light emitting areas EA3 and directed in diagonal directions DR4 and DR5, respectively, intersecting the first and second directions DR1 and DR2, respectively.

In an embodiment, pixels PX that display each luminance and color may be provided by the first light emitting area EA1, the second light emitting area EA2, and the third light emitting area EA3 disposed adjacent to each other among the light emitting areas EA.

In other words, the pixels PX may be basic units that display various colors, including white, at predetermined luminance.

In an embodiment, each of the pixels PX may include at least one first light emitting area EA1, at least one second light emitting area EA2, and at least one third light emitting area EA3 disposed adjacent to each other. Accordingly, each of the pixels PX may display various colors through mixing of light emitted from the light emitting areas EA1, EA2, and EA3 disposed adjacent to each other.

In an embodiment and as illustrated in FIG. 4, the sub-area SBA may protrude from at least a portion of the second side SD2 of the main area MA.

The sub-area SBA may include a bending area BA that is deformed into a bent shape, and a pad area PDA connected to the bending area BA.

In an embodiment and as illustrated in FIG. 3, when the bending area BA is deformed into the bent shape, the pad area PDA may be disposed on a rear surface of the display panel 100.

In an embodiment, the pad area PDA may be fixed to the rear surface of the display panel 100 through an additional adhesive layer ADH.

According to an embodiment, the display panel 100 may further include a sealing layer 140 disposed on the element layer 130, a touch sensor layer 150 disposed on the sealing layer 140, and a polarizing layer 160 disposed on the touch sensor layer 150.

In an embodiment, the sealing layer 140 may be disposed on the element layer 130 and may have a structure in which two or more inorganic films and at least one organic film are alternately stacked.

In an embodiment, the touch sensor layer 150 may include touch electrodes for detecting a signal that varies depending on a touch of a person or object and sensing a point in the main area MA where the touch of the person or object occurred.

In an embodiment, the polarizing layer 160 is intended to prevent image visibility from being reduced due to reflection of external light by blocking external light reflected from the touch sensor layer 150, the sealing layer 140, the element layer 130, and the circuit layer 120 and interfaces disposed therebetween.

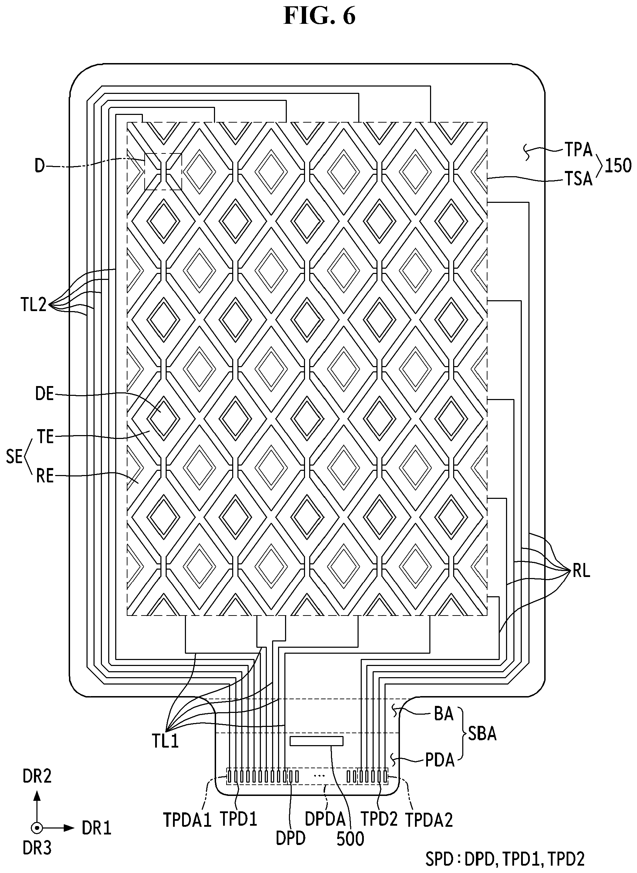

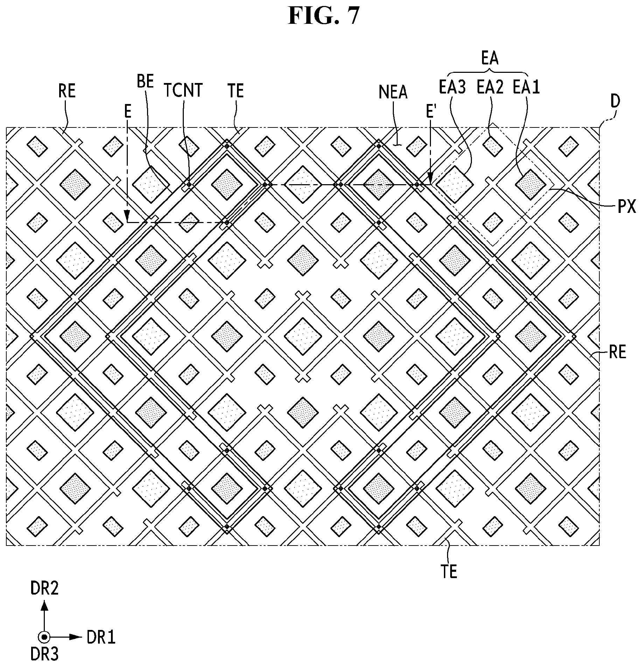

FIG. 6 is a layout view illustrating a touch sensor layer of FIG. 3, according to an embodiment. FIG. 7 is a detailed plan view illustrating portion D of FIG. 6, according to an embodiment.

FIGS. 6 and 7 illustrate an embodiment of a capacitive touch sensor layer 150. In this case, the display device 10 may further include a touch driving circuit that senses touch based on whether or not a capacitance changes.

In an embodiment, the touch driving circuit may be mounted on a pad area PDA of the substrate 110 or on a circuit board. However, the illustration in FIGS. 6 and 7 is merely an example for convenience of explanation, and the touch sensor layer 150 according to an embodiment is not limited to the illustration in FIGS. 6 and 7.

FIG. 6 illustrates only some of the components of the touch sensor layer 150 for convenience of explanation.

In an embodiment and referring to FIG. 6, the touch sensor layer 150 may be disposed in the main area MA of the substrate 110. The touch sensor layer 150 may include a touch sensing area TSA for detecting a user's touch and a touch peripheral area TPA around the touch sensing area TSA.

In an embodiment, the touch sensing area TSA may be wider than the display area DA and may be similar to the display area DA. Accordingly, the touch peripheral area TPA disposed around the touch sensing area TSA may be similar to the non-display area NDA around the display area DA.

In an embodiment, the touch sensing area TSA may overlap the display area DA and the edge of the non-display area NDA disposed adjacent to the display area DA. In this case, the touch peripheral area TPA may overlap the remaining portion of the non-display area NDA that does not correspond to the touch sensing area TSA.

In an embodiment, the touch sensor layer 150 may include sensor electrodes SE and dummy electrodes DE arranged in a matrix in the touch sensing area TSA and generating mutual capacitance, and sensor lines TL1, TL2, and RL disposed in the touch peripheral area TPA.

In an embodiment, the sensor electrodes SE may include a driving electrode TE to which a driving signal is applied, and a sensing electrode RE for sensing a voltage charged in the mutual capacitance with the driving electrode TE.

In an embodiment, the sensor lines may include a first driving line TL1, a second driving line TL2, and a sensing line RL.

In an embodiment, each of the first driving line TL1 and the second driving line TL2 may be electrically connected to two or more driving electrodes TE that are directed parallel in the second direction DR2.

In an embodiment, the driving electrodes TE disposed adjacent to each other in the second direction DR2 may be electrically connected to each other through a bridge electrode (BE in FIG. 7).

In an embodiment, the first driving line TL1 may extend from one side of the touch sensing area TSA facing the sub-area SBA and extending in the first direction DR1 to the sub-area SBA.

In an embodiment, the second driving line TL2 may extend from the other side of the touch sensing area TSA facing one side of the touch sensing area TSA in the second direction DR2 and extending in the first direction DR1 to the sub-area SBA.

In an embodiment, a portion of the second driving line TL2 may be disposed to be directed parallel to one side of the touch sensing area TSA extending in the second direction DR2.

In an embodiment, the sensing line RL may be electrically connected to two or more sensing electrodes RE that are directed parallel in the first direction DR1 among the sensing electrodes RE.

In an embodiment, the sensing electrodes RE disposed adjacent to each other in the first direction DR1 may be electrically connected to each other through a protruding portion in the first direction DR1.

In an embodiment, the sensing lines RL may extend from the other side of the touch sensing area TSA extending in the second direction DR2 to the sub-area SBA.

In an embodiment, each of the driving electrodes TE and the sensing electrodes RE may have a shape surrounding a dummy electrode DE disposed at each center.

In an embodiment, the dummy electrode DE may be spaced apart from the driving electrode TE and the sensing electrode RE surrounding each dummy electrode DE. The dummy electrode DE may be maintained in a floating state.

In an embodiment, FIG. 6 illustrates the driving electrode TE, the sensing electrode RE, and the dummy electrode DE each having a rhombic planar shape, but the touch sensor layer 150, according to the an embodiment, is not limited to the illustration in FIG. 6. In another embodiment, the planar shape of the driving electrode TE, the sensing electrode RE, and the dummy electrode DE may be a quadrangle other than a rhombus, a polygon other than a quadrangle, a circle, or an oval.

According to an embodiment, the display panel 100 may include signal pads SPD disposed in the pad area PDA of the sub-area SBA of the substrate 110 and to which the circuit board is connected.

In an embodiment, the pad area PDA may include a display pad area DPDA disposed adjacent to a display driving circuit 700, and a first touch pad area TPDA1 and a second touch pad area TPDA2 disposed on both sides of the display pad area DPDA.

In an embodiment, the signal pads SPD may include display signal pads DPD disposed in the display pad area DPDA, and first touch pads TPD1 and second touch pads TPD2 disposed in the first touch pad area TPDA1 and the second touch pad area TPDA2.

In an embodiment, the display signal pads DPD may be electrically connected to the circuit layer 120 or the display driving circuit 700.

In an embodiment, the first touch pads TPD1 may be electrically connected to the first driving line TL1 and the second driving line TL2.

In an embodiment, the second touch pads TPD2 may be electrically connected to the sensing lines RL.

In an embodiment and referring to FIG. 7, the touch sensor layer 150 may further include a bridge electrode BE that electrically connects the driving electrodes TE disposed adjacent to each other in the second direction DR2.

In an embodiment, the bridge electrode BE may be electrically connected to the driving electrodes TE through touch electrode connection holes TCNT.

In an embodiment, the driving electrodes TE disposed adjacent to each other in the second direction DR2 may be electrically connected to each other through two or more bridge electrodes BE. In this way, reliability of an electrical connection between the driving electrodes TE may be improved.

In an embodiment, FIG. 7 illustrates that two bridge electrodes BE directed parallel to each other are disposed between the driving electrodes TE disposed adjacent to each other in the second direction DR2, but the touch sensor layer 150, according to an embodiment, is not limited to the illustration in FIG. 7.

FIG. 7 illustrates a bridge electrode BE having a shape including once bending, according to an embodiment. However, the shape of the bridge electrode BE, according to embodiments, is not limited to the illustration in FIG. 7.

In an embodiment, the driving electrode TE and the sensing electrode RE may be spaced apart from each other.

In an embodiment, the bridge electrode BE may be disposed on a different conductive layer from the driving electrode TE and the sensing electrode RE.

In an embodiment, each of the driving electrode TE, the sensing electrode RE, and the bridge electrode BE may have a planar shape of a mesh or net structure. The dummy electrode DE may also have a planar shape of a mesh or net structure. In this way, since the width of the light emitting areas EA overlapping the driving electrode TE, the sensing electrode RE, the dummy electrode DE, and the bridge electrode BE may be reduced, a decrease in light emission efficiency of the light emitting areas EA due to the driving electrode TE, the sensing electrode RE, the dummy electrode DE, and the bridge electrode BE may be reduced.

FIG. 8 is an equivalent circuit diagram illustrating a light emitting pixel driver of FIG. 5, according to an embodiment.

In an embodiment and referring to FIG. 8, the circuit layer (120 in FIG. 3) may include a first power line VDL that transmits a first power ELVDD to the light emitting pixel drivers EPD, a second power line that transmits a second power ELVSS to the light emitting elements LE, a gate initialization voltage line VGIL that transmits a gate initialization voltage VGINT to the light emitting pixel drivers EPD, and an anode initialization voltage line VAIL that transmits an anode initialization voltage VAINT.

In an embodiment, the light emitting elements LE of the element layer (130 in FIG. 3) may be electrically connected between the light emitting pixel drivers EPD and the second power ELVSS.

That is, one of the light emitting elements LE may be electrically connected between one of the light emitting pixel drivers EPD of the circuit layer 120 and the second power ELVSS.

In an embodiment, the second power ELVSS may have a lower voltage level than the first power ELVDD.

That is, in an embodiment, an anode electrode of the light emitting element LE may be electrically connected to the light emitting pixel driver EPD, and the second power ELVSS having the lower voltage level than the first power ELVDD may be applied to a cathode electrode of the light emitting element LE.

In an embodiment, a capacitor Cel which is connected in parallel with the light emitting element LE represents a parasitic capacitance between the anode electrode and the cathode electrode.

In an embodiment, the circuit layer 120 may include a data line DL that transmits a data signal Vdata, a scan write line GWL that transmits a scan write signal GW, a scan initialization line GIL that transmits a scan initialization signal GI, a gate control line GCL that transmits a gate control signal GC, and an emission control line ECL that transmits an emission control signal EC.

In an embodiment, one light emitting pixel driver EPD of the circuit layer 120 may include a first transistor T1 that generates a driving current for driving the light emitting element LE, two or more transistors T2 to T6 electrically connected to the first transistor T1, and at least one pixel capacitor PC1.

In an embodiment, the first transistor T1 may be disposed between a first node N1 and a second node N2. The first node N1 is electrically connected to a first electrode (e.g., a source electrode) of the first transistor T1. The second node N2 is electrically connected to a second electrode (e.g., a drain electrode) of the first transistor T1.

In an embodiment, the second transistor T2 may be electrically connected between the data line DL and the first node N1.

Additionally, the second transistor T2 may be turned on by the scan write signal GW of the scan write line GWL.

In an embodiment, the first electrode of the first transistor T1 may be electrically connected to the data line DL through the turned-on second transistor T2.

In an embodiment, the pixel capacitor PC1 may be electrically connected between the first power line VDL and a third node N3. The third node N3 is electrically connected to a gate electrode of the first transistor T1.

That is, the gate electrode of the first transistor T1 may be electrically connected to the first power line VDL through the first capacitor PC1.

In an embodiment, the fifth transistor T5 may be electrically connected between the first node N1 and the first power line VDL.

In an embodiment, the sixth transistor T6 may be electrically connected between the second node N2 and a fourth node N4, where the fourth node N4 is electrically connected to the anode electrode of the light emitting element LE.

That is, the fifth transistor T5 may be electrically connected between the first electrode of the first transistor T1 and the first power line VDL.

In an embodiment, the sixth transistor T6 may be electrically connected between the second electrode of the first transistor T1 and the anode electrode of the light emitting element LE.

In an embodiment, the fifth transistor T5 and the sixth transistor T6 may be turned on by the emission control signal EC of the emission control line ECL.

In an embodiment, when the data signal Vdata of the data line DL is transmitted to the first electrode of the first transistor T1 through the turned-on second transistor T2, a voltage difference between the gate electrode of the first transistor T1 and the first electrode of the first transistor T1 may correspond to a difference voltage between the first power ELVDD and the data signal Vdata.

In this case, when the voltage difference between the gate electrode of the first transistor T1 and the first electrode of the first transistor T1, that is, a gate-source voltage difference is a threshold voltage or more, the first transistor T1 may be turned on, thereby generating a drain-source current of the first transistor T1 corresponding to the data signal Vdata.

Subsequently, when the fifth transistor T5 and the sixth transistor T6 are turned on, the first power ELVDD, the first transistor T1, the light emitting element LE, and the second power ELVSS may be connected in series with each other. Accordingly, the drain-source current of the first transistor T1 corresponding to the data signal Vdata may be supplied as a driving current of the light emitting element LE.

As a result, the light emitting element LE may emit light with luminance corresponding to the data signal Vdata.

In an embodiment, the third transistor T3 may be disposed between the second node N2 and the third node N3. That is, the third transistor T3 may be electrically connected between the gate electrode of the first transistor T1 and the second electrode of the first transistor T1.

In an embodiment, the third transistor T3 may include a plurality of sub-transistors connected in series with each other. As an example, the third transistor T3 may include a first sub-transistor T31 and a second sub-transistor T32.

In an embodiment, a first electrode of the first sub-transistor T31 may be connected to the gate electrode of the first transistor T1, a second electrode of the first sub-transistor T31 may be connected to a first electrode of the second sub-transistor T32, and a second electrode of the second sub-transistor T32 may be connected to the second electrode of the first transistor T1.

In this way, the potential of the gate electrode of the first transistor T1 may be prevented from being changed due to a leakage current caused by the third transistor T3 that is not turned on.

In an embodiment, the first sub-transistor T31 and the second sub-transistor T32 may be turned on by the scan write signal GW of the scan write line GWL.

When the first sub-transistor T31 and the second sub-transistor T32 are turned on, the voltage difference between the second node N2 and the third node N3 may be initialized.

In an embodiment, the fourth transistor T4 may be electrically connected between the gate initialization voltage line VGIL and the third node N3. That is, the fourth transistor T4 may be connected between the gate electrode of the first transistor T1 and the gate initialization voltage line VGIL.

In an embodiment, the fourth transistor T4 may include a plurality of sub-transistors connected in series with each other. As an example, the fourth transistor T4 may include a third sub-transistor T41 and a fourth sub-transistor T42.

In an embodiment, a first electrode of the third sub-transistor T41 may be connected to the gate electrode of the first transistor T1, a second electrode of the third sub-transistor T41 may be connected to a first electrode of the fourth sub-transistor T42, and a second electrode of the fourth sub-transistor T42 may be connected to the gate initialization voltage line VGIL.

In this way, the potential of the gate electrode of the first transistor T1 may be prevented from being changed due to a leakage current caused by the fourth transistor T4 that is not turned on.

In an embodiment, the third sub-transistor T41 and the fourth sub-transistor T42 may be turned on by the scan initialization signal GI of the scan initialization line GIL.

When the third sub-transistor T41 and the fourth sub-transistor T42 are turned on, the potential of the third node N3 may be initialized to the gate initialization voltage VGINT.

In an embodiment, the seventh transistor T7 may be electrically connected between the fourth node N4 and the anode initialization voltage line VAIL. That is, the seventh transistor T7 may be electrically connected between the anode electrode of the light emitting element LE and the anode initialization voltage line VAIL.

The seventh transistor T7 may be turned on by the gate control signal GC of the gate control line GCL.

In an embodiment, a potential of the fourth node N4 may be initialized to the anode initialization voltage VAINT through the turned-on seventh transistor T7.

In an embodiment, FIG. 8 illustrates a light emitting pixel driver EPD including first to seventh transistors T1 to T7, respectively, formed as P-type MOSFETs. However, this is only an example, and at least one of the transistors T1 to T7 may be an N-type MOSFET. As an example, the third transistor T3 and the fourth transistor T4 may be N-type MOSFETs.

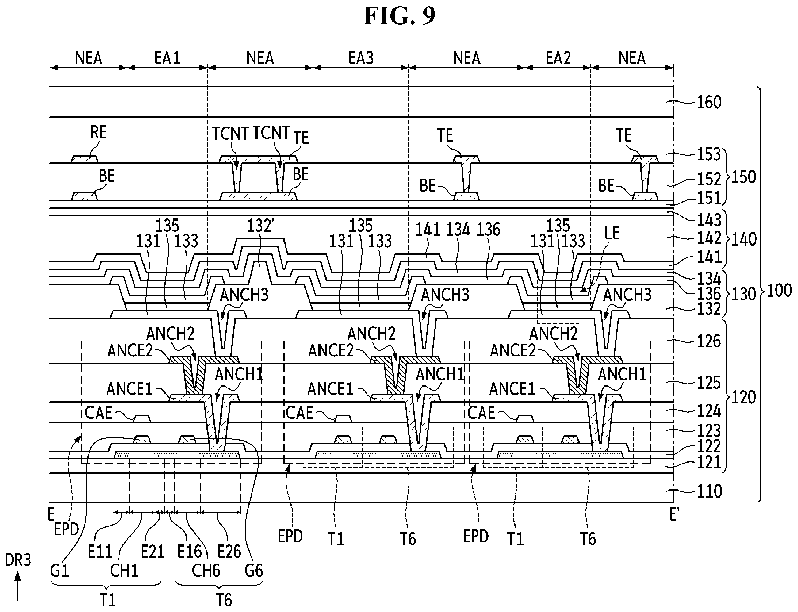

FIG. 9 is a cross-sectional view taken along line E-E' of FIG. 7, according to an embodiment.

In an embodiment and referring to FIG. 9, the display panel 100 of the display device 10 may include a substrate 110, a circuit layer 120 disposed on the substrate 110, and an element layer 130 disposed on the circuit layer 120.

In an embodiment, the display panel 100 of the display device 10 may further include a sealing layer 140 disposed on the element layer 130, a touch sensor layer 150 disposed on the sealing layer 140, and a polarizing layer 160 disposed on the touch sensor layer 150.

In an embodiment, the circuit layer 120 may include first semiconductor layers CH1, E11, E21, CH6, E16, and E26 disposed on the substrate 110, a first gate insulating layer 122 covering the first semiconductor layers, first gate conductive layers G1 and G6 disposed on the first gate insulating layer 122, a second gate insulating layer 123 covering the first gate conductive layers, a second gate conductive layer (a capacitor electrode CAE) disposed on the second gate insulating layer 123, an interlayer insulating layer 124 disposed on the second gate conductive layer, a first source-drain conductive layer (a first anode connection electrode ANCE1) disposed on the interlayer insulating layer 124, a first planarization layer 125 covering the first source-drain conductive layer, a second source-drain conductive layer (a data line DL and a second anode connection electrode ANCE2) disposed on the first planarization layer 125, and a second planarization layer 126 covering the second source-drain conductive layer.

In an embodiment, the circuit layer 120 may further include a buffer layer 121 covering the substrate 110.

In this embodiment, the first semiconductor layers CH1, E11, E21, CH6, E16, and E26 may be disposed on the buffer layer 121.

In an embodiment, the circuit layer 120 may include light emitting pixel drivers EPD each corresponding to the light emitting areas EA.

In an embodiment, each of the light emitting pixel drivers EPD may include a first transistor T1, and second to seventh transistors (T2 to T7 in FIG. 8, respectively) and at least one capacitor (PC1 in FIG. 8) electrically connected to the first transistor T1.

FIG. 9 illustrates the first transistor T1 and the sixth transistor T6 of the light emitting pixel driver EPD of FIG. 8, and the light emitting element LE, according to an embodiment.

In an embodiment, the first semiconductor layers on the buffer layer 121 may include channel portions CH1 and CH6, first electrode portions E11 and E16, and second electrode portions E21 and E26 of each of the transistors T1 to T7.

In an embodiment, in each of the first transistor T1 and the sixth transistor T6, the first electrode portions E11 and E16 may be connected to one end of the channel portions CH1 and CH6, and the second electrode portions E21 and E26 may be connected to other ends of the channel portions CH1 and CH6.

In an embodiment, the second electrode portion E21 of the first transistor T1 may be connected to the first electrode portion E16 of the sixth transistor T6.

In an embodiment, the first gate conductive layers on the first gate insulating layer 122 may include gate electrodes G1 and G6 of each of the transistors T1 to T7.

In an embodiment, in each of the first transistor T1 and the sixth transistor T6, the gate electrodes G1 and G6 may overlap the channel portions CH1 and CH6.

Since the second transistor T2, the first sub-transistor T31, the second sub-transistor T32, the third sub-transistor T41, the fourth sub-transistor T42, the fifth transistor T5, and the seventh transistor T7 of the light emitting pixel driver EPD are provided as the same P-type MOSFET as the first transistor T1 and the sixth transistor T6, the overlapping descriptions will be omitted below.

In an embodiment, the second gate conductive layers on the second gate insulating layer 123 may include a capacitor electrode CAE.

The capacitor electrode CAE may overlap the gate electrode G1 of the first transistor T1.

In an embodiment, a pixel capacitor (PC1 in FIG. 8) may be provided by an overlapping area between the capacitor electrode CAE and the gate electrode G1 of the first transistor T1.

In an embodiment, the first source drain conductive layer on the interlayer insulating layer 124 may include a first anode connection electrode ANCE1.

The first anode connection electrode ANCE1 may be electrically connected to the second electrode portion E26 of the sixth transistor T6 through a first anode connection hole ANCH1.

In an embodiment, the second source drain conductive layer on the first planarization layer 125 may include a second anode connection electrode ANCE2.

The second anode connection electrode ANCE2 may be electrically connected to the first anode connection electrode ANCE1 through a second anode connection hole ANCH2.

In an embodiment, the anode electrode 131 of the element layer 130 may be disposed on the second planarization layer 126, and may be electrically connected to the second anode connection electrode ANCE2 through a third anode connection hole ANCH3.

As a result, the anode electrode 131 may be electrically connected to the second electrode portion E26 of the sixth transistor T6 through the first anode connection electrode ANCE1 and the second anode connection electrode ANCE2.

In an embodiment, the element layer 130 on the circuit layer 120 may include light emitting elements LE disposed in the light emitting areas EA1, EA2, and EA3, respectively.

In an embodiment, each of the light emitting elements LE may include a structure in which the light emitting layer 133 is disposed between the anode electrode 131 and the cathode electrode 134 that face each other.

According to an embodiment, the element layer 130 may include anode electrodes 131 each disposed in the light emitting areas EA, a pixel defining layer 132 disposed in the non-light emitting area NEA and covering an edge of the anode electrode 131, a spacer layer 132' disposed on a portion of the pixel defining layer 132, light emitting layers 133 each disposed on the anode electrodes 131, and a cathode electrode 134 disposed on the light emitting layers 133, the pixel defining layer 132, and the spacer layer 132'.

In another embodiment, each of the light emitting elements LE may further include first common layers 135 disposed between the anode electrodes 131 and the light emitting layers 133, and a second common layer 136 disposed between the light emitting layers 133 and the cathode electrode 134.

In an embodiment, the sealing layer 140 may be disposed on the circuit layer 120 and cover the element layer 130.

The sealing layer 140 is used to block permeation of oxygen or moisture into the element layer 130 and to relieve electrical or physical shock to the circuit layer 120 and the element layer 130.

In an embodiment, the sealing layer 140 may include a first sealing layer 141 disposed on the circuit layer 120, covering the element layer 130, and including an inorganic insulating material, a second sealing layer 142 disposed on the first sealing layer 141, overlapping the element layer 130, and including an organic insulating material, and a third sealing layer 143 disposed on the first sealing layer 141, covering the second sealing layer 142, and including an inorganic insulating material.

In an embodiment, the touch sensor layer 150 may be disposed on the sealing layer 140.

The touch sensor layer 150 may include a touch buffer layer 151 disposed on the sealing layer 140, a first touch conductive layer BE disposed on the touch buffer layer 151, a touch interlayer insulating layer 152 covering the first touch conductive layer, second touch conductive layers TE and RE disposed on the touch interlayer insulating layer 152, and a touch planarization layer 153 covering the second touch conductive layers.

In an embodiment, the first touch conductive layer on the touch buffer layer 151 may include a bridge electrode BE.

In an embodiment, the second touch conductive layers on the touch interlayer insulating layer 152 may include a driving electrode TE and a sensing electrode RE.

In an embodiment, the dummy electrode DE disposed inside each of the driving electrode TE and the sensing electrode RE, the first driving line TL1 and the second driving line TL2 connected to the driving electrode TE, and the sensing line RL connected to the sensing electrode RE may be disposed in the second touch conductive layer on the touch interlayer insulating layer 152, like the driving electrode TE and the sensing electrode RE.

In an embodiment, the driving electrode TE may be electrically connected to the bridge electrode BE through the touch electrode connection hole TCNT which is penetrating through the touch interlayer insulating layer 152.

In an embodiment, the touch buffer layer 151 may include an inorganic insulating material.

According to an embodiment, the touch planarization layer 153 may include an organic insulating material.

In an embodiment, the polarizing layer 160 may be disposed on the touch sensor layer 150.

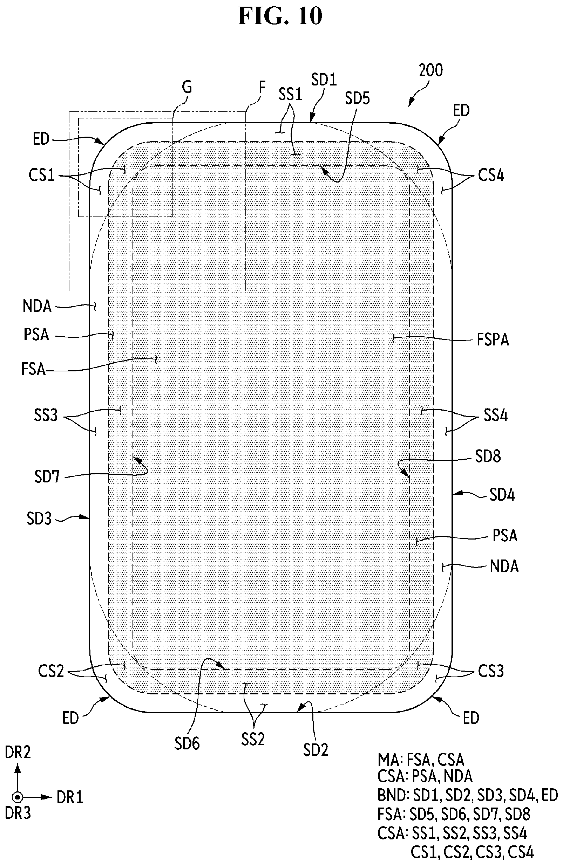

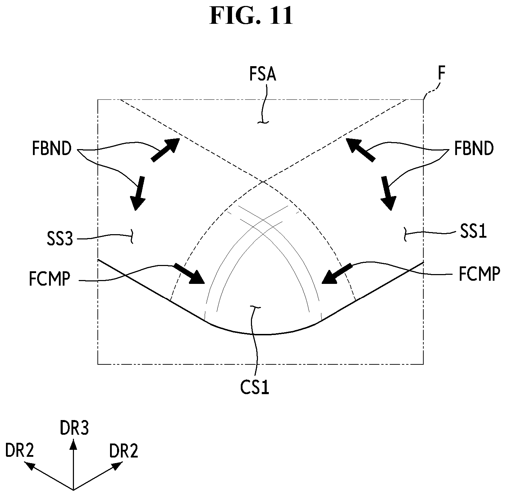

FIG. 10 is a plan view illustrating a metal plate of FIG. 2, according to an embodiment. FIG. 11 is a perspective view illustrating portion F of FIG. 10 of the metal plate of FIG. 2, according to an embodiment.

In an embodiment and referring to FIG. 10, the metal plate 200 of the display device 10 includes a main area MA, similarly to the substrate 110 of the display panel 100.

That is, the metal plate 200 may include a flat display area FSA having a flat shape and a curved area CSA having a curved shape.

In an embodiment, the edge BND of the main area MA may include a first side SD1 and a second side SD2 extending in a first direction DR1 and opposing each other in a second direction DR2, a third side SD3 and a fourth side SD4 extending in the second direction DR2 and opposing each other in the first direction DR1, and corners ED connecting two sides ED.

In an embodiment, the flat display area FSA may include a fifth side SD5 and a sixth side SD6 extending in the first direction DR1 and opposing each other in the second direction DR2, and a seventh side SD7 and an eighth side SD8 extending in the second direction DR2 and opposing each other in the first direction DR1.

In an embodiment, the curved area CSA may include a first side area SS1 disposed between the first side SD1 and the fifth side SD5, a second side area SS2 disposed between the second side SD2 and the sixth side SD6, a third side area SS3 disposed between the third side SD3 and the seventh side SD7, a fourth side area SS4 disposed between the fourth side SD4 and the eighth side SD8, a first corner area CS1 in contact with a vertex between the fifth side SD5 and the seventh side SD7 and disposed between the first side area SS1 and the third side area SS3, a second corner area CS2 in contact with a vertex between the sixth side SD6 and the seventh side SD7 and disposed between the second side area SS2 and the third side area SS3, a third corner area CS3 in contact with a vertex between the sixth side SD6 and the eighth side SD8 and disposed between the second side area SS2 and the fourth side area SS4, and a fourth corner area CS4 in contact with a vertex between the fifth side SD5 and the eighth side SD8 and disposed between the first side area SS1 and the fourth side area SS4.

In an embodiment, each of the first side area SS1, the second side area SS2, the third side area SS3, the fourth side area SS4, the first corner area CS1, the second corner area CS2, the third corner area CS3, and the fourth corner area CS4 may include a peripheral display area PSA and a non-display area NDA.

In an embodiment, the first side area SS1 may have a shape that extends from the fifth side SD5 and that is curved with a first curvature radius in a direction opposite to the direction in which light is emitted.

In an embodiment, the second side area SS2 may have a shape that extends from the sixth side SD6 and is curved with a second curvature radius in a direction opposite to the direction in which light is emitted. The second curvature radius may be in the same range as the first curvature radius.

In an embodiment, the third side area SS3 may have a shape that extends from the seventh side SD7 and is curved with a third curvature radius in a direction opposite to the direction in which light is emitted. The third curvature radius may be the same as or in a similar range as the first or second curvature radius, but is not limited thereto.

In an embodiment, the fourth side area SS4 may have a shape that extends from the eighth side SD8 and is curved with a fourth curvature radius in a direction opposite to the direction in which light is emitted. The fourth curvature radius may be in the same range as the third curvature radius.

In an embodiment, the first corner area CS1 may be disposed between one side of the first side area SS1 and one side of the third side area SS3.

The first corner area CS1 may be a double curvature area that is curved with the first curvature radius of the first side area SS1 and the third curvature radius of the third side area SS3.

In an embodiment, the second corner area CS2 may be disposed between one side of the second side area SS2 and one side of the third side area SS3.

The second corner area CS2 may be a double curvature area that is curved with the second curvature radius of the second side area SS2 and the third curvature radius of the third side area SS3.

In an embodiment, the third corner area CS3 may be disposed between one side of the second side area SS2 and one side of the fourth side area SS4.

The third corner area CS3 may be a double curvature area that is curved with the second curvature radius of the second side area SS2 and the fourth curvature radius of the fourth side area SS4.

In an embodiment, the fourth corner area CS4 may be disposed between the other side of the first side area SS1 and the other side of the fourth side area SS4.

The fourth corner area CS4 may be a double curvature area that is curved with the first curvature radius of the first side area SS1 and the fourth curvature radius of the fourth side area SS4.

In an embodiment and referring to FIGS. 10 and 11, the first side area SS1 may have a shape that extends from the fifth side SD5 and that is curved with a first curvature radius in a direction opposite to the direction in which light is emitted.

In an embodiment, the third side area SS3 may have a shape that extends from the seventh side SD7 and that is curved with a third curvature radius in a direction opposite to the direction in which light is emitted.

In an embodiment, each of the first side area SS1 and the third side area SS3 may be deformed into a bent shape by a bending force FBND.

In an embodiment, the first corner area CS1 may be disposed between one side of the first side area SS1 and one side of the third side area SS3.

In an embodiment, the first corner area CS1 may be a double curvature area that is curved with the first curvature radius of the first side area SS1 and the third curvature radius of the third side area SS3.

That is, the first corner area CS1 may be deformed into a double curvature shape by a force FCMP that compresses toward the corner (ED in FIG. 10).

Due to this, as the compressive force FCMP is partially applied more strongly closer to the corner (ED of FIG. 10) in the first corner area CS1, a buckling defect in which the metal plate 200 is deformed into an uneven shape may occur.

In addition, in a process of attaching the cover window 300 after the display panel 100 and the metal plate 200 are deformed by applying the bending force FBND to the curved area CSA, a restoration defect in which the metal plate 200 is partially restored to the flat shape due to a repulsive force of the metal plate 200 may occur. In addition, as the display panel 100 is restored together with the metal plate 200 due to the restoration defect of the metal plate 200, air bubbles may be inserted into the transparent adhesive layer 400 between the display panel 100 and the cover window 300. Since the air bubbles in the transparent adhesive layer 400 reduce light emission efficiency of the display panel 100, a display quality of the display device 10 may deteriorate.

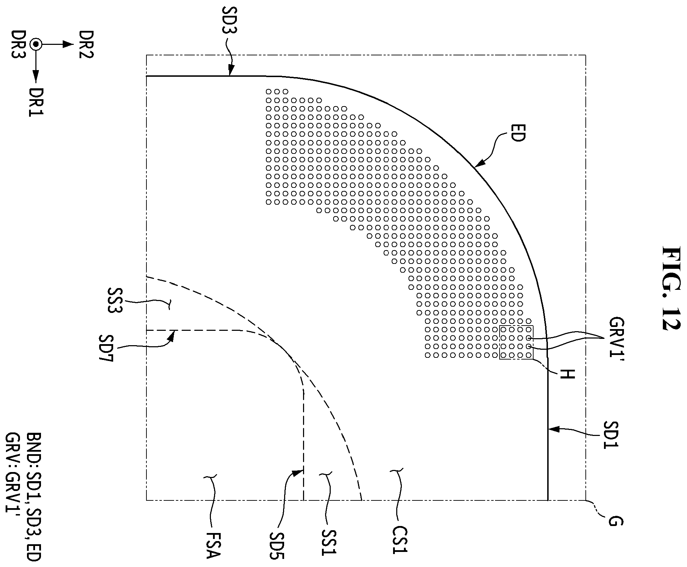

Accordingly, in order to reduce the buckling defect or restoration defect of the metal plate 200 for improving a display quality, the display device 10, according to an embodiment, may include the plurality of grooves (GRV in FIGS. 12, 14, 18, 19, 21, 23, and 24) formed in at least a portion of the edge of the metal plate 200 and penetrating through at least a portion of the metal plate 200.

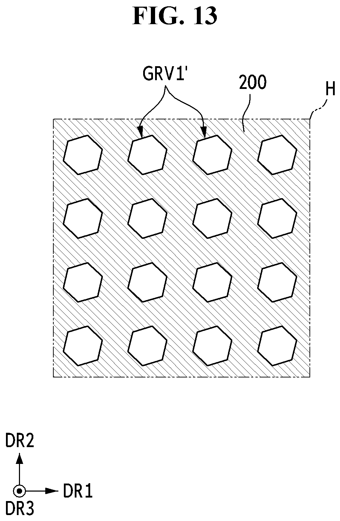

FIG. 12 is a plan view illustrating portion G of FIG. 10, according to an embodiment. FIG. 13 is an enlarged view illustrating portion H of FIG. 12, according to an embodiment.

In an embodiment and as illustrated in FIG. 12, the display device 10 may include a plurality of grooves GRV formed in at least a portion of the edge of the metal plate 200 and penetrating through at least a portion of the metal plate 200.

According to an embodiment, the plurality of grooves GRV may include first grooves GRV1' formed in a portion of the curved area CSA, disposed adjacent to at least one of the corners ED, and spaced apart from the edge BND of the main area MA.

That is, the first grooves GRV1' may be formed in at least one of the first corner area CS1, the second corner area (CS2 in FIG. 10), the third corner area (CS3 in FIG. 10), and the fourth corner area (CS4 in FIG. 10).

According to an embodiment, the first grooves GRV1' may have a polygonal or circular shape. The first grooves GRV1' may be disposed to be parallel in directions intersecting each other. E.g., the first grooves GRV1' may be arranged to be parallel to each other in the first direction DR1 and the second direction DR2.

In an embodiment and as illustrated in FIG. 13, the first grooves GRV1' may have a hexagonal shape and may be arranged to be parallel to each other in the first direction DR1 and the second direction DR2.

As described above, according to an embodiment, the first grooves GRV1' penetrating through at least a portion of the metal plate 200 may be formed in the first corner area CS1, the second corner area (CS2 in FIG. 10), the third corner area (CS3 in FIG. 10), and the fourth corner area (CS4 in FIG. 10). Accordingly, even if compressive stress (FCMP in FIG. 11) for deforming the first corner area CS1, the second corner area (CS2 in FIG. 10), the third corner area (CS3 in FIG. 10), and the fourth corner area (CS4 in FIG. 10) into a double curvature area is partially concentrated on the metal plate 200, the buckling defect of the metal plate 200 may be prevented because the compressive stress (FCMP in FIG. 11) may be distributed while the width or spacing of the first grooves GRV1' is deformed.

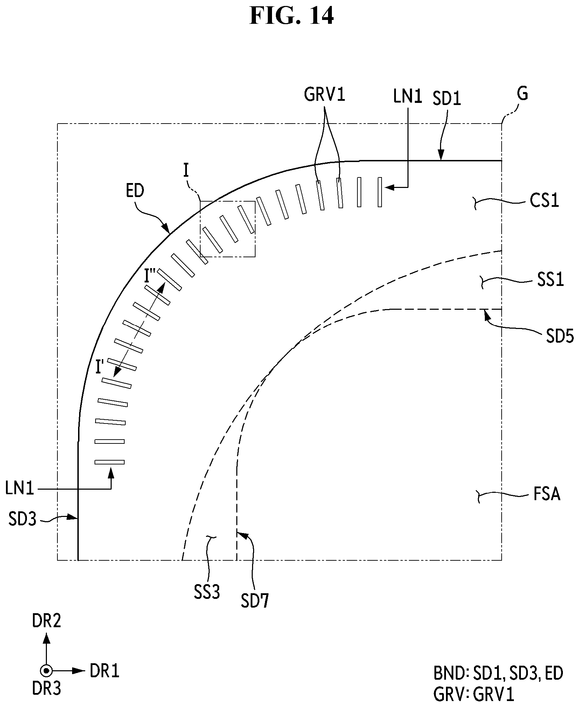

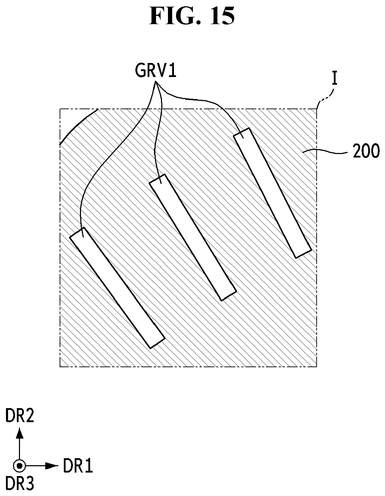

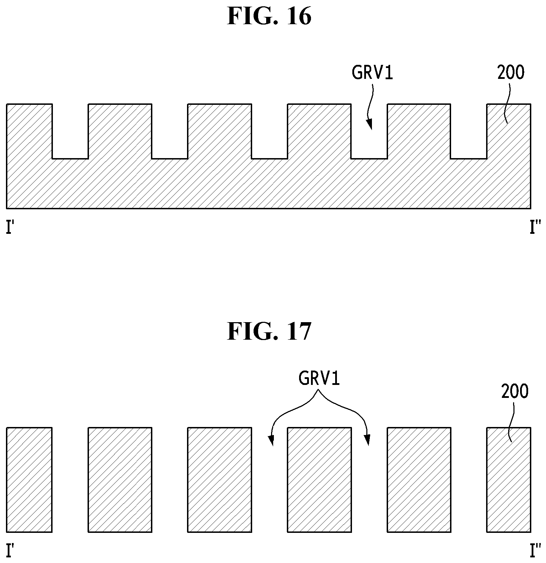

FIG. 14 is a plan view illustrating portion G of FIG. 10, according to an embodiment. FIG. 15 is an enlarged view illustrating portion I of FIG. 14, according to an embodiment. FIGS. 16 and 17 are cross-sectional views taken along line I'-I" of FIG. 14, according to embodiments.

Since the display device 10, according to an embodiment illustrated in FIGS. 14 and 15 is substantially the same as the display device according to the embodiments of FIGS. 1 to 11, except that the plurality of grooves GRV include first grooves GRV1 having a slit shape, the redundant description will be omitted below.

As illustrated in FIG. 15, according to an embodiment, the first grooves GRV1 may have a slit shape. The first grooves GRV1 having the slit shape may extend in a direction intersecting the edge BND of the main area MA. For example, the first grooves GRV1 having the slit shape may extend in a direction toward the edge.

In an embodiment and as illustrated in FIG. 16, each of the first grooves GRV1 may be formed to a depth that penetrates through at least half of a thickness of the metal plate 200 (but less than an entire thickness of the metal plate 200).

In another embodiment, as illustrated in FIG. 17, each of the first grooves GRV1 may be formed to a depth that entirely penetrates through the thickness of the metal plate 200.

That is, each of the first grooves GRV1 may penetrate through at least a portion of the metal plate 200.

In an embodiment and as illustrated in FIG. 14, the first grooves GRV1 may be spaced apart from the edge BND of the main area MA by a critical distance or more.

In addition, according to an embodiment, a first line LN1 on which the first grooves GRV1 are arranged in parallel with each other may be parallel to the edge BND of the main area MA.

In an embodiment, the first grooves GRV1 (e.g. the slit shapes thereof) may have the same length.

In an embodiment, the first grooves GRV1 (e.g. the slit shapes thereof) may be arranged at equal intervals on the first line LN1.

In an embodiment, the first grooves GRV1 may be further arranged in a portion of at least one of the first side area SS1, the second side area (SS2 in FIG. 10), the third side area SS3, and the fourth side area (SS4 in FIG. 10).

That is, the arrangement of the first grooves GRV1 may also be extended to portions of both sides of each of the first side area SS1, the second side area (SS2 in FIG. 10), the third side area (SS3 in FIG. 10), and the fourth side area (SS4 in FIG. 10) disposed adjacent to the first corner area CS1, the second corner area (CS2 in FIG. 10), the third corner area (CS3 in FIG. 10), and the fourth corner area (CS4 in FIG. 10).

As described above, according to the embodiment of FIGS. 14 and 15, since the compressive stress (FCMP in FIG. 11) for deformation into the double curvature area may be distributed relatively evenly at the edge of the metal plate 200 by the first grooves GRV1 having the slit shape, and especially when being arranged in parallel with the same length and the same spacing, the buckling defect of the metal plate 200 may be further prevented.

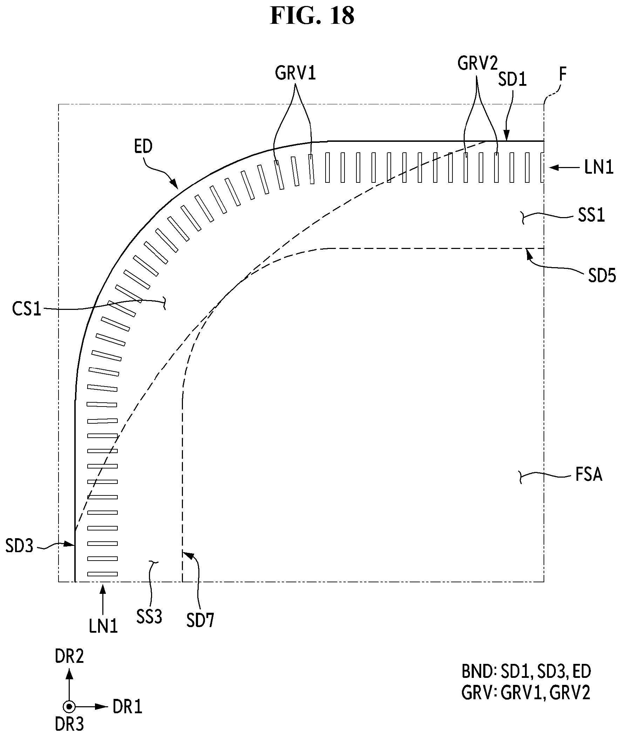

FIG. 18 is a plan view illustrating portion F of FIG. 10, according to an embodiment.

Since the display device 10 according to an embodiment illustrated in FIG. 18 is substantially the same as the display device according to the embodiment of FIGS. 14 and 15, except that the plurality of grooves GRV further include second grooves GRV2, the redundant description will be omitted below.

In an embodiment, the second grooves GRV2 may be formed in at least one of the first side area SS1, the second side area (SS2 in FIG. 10), the third side area (SS3 in FIG. 10), and the fourth side area (SS4 in FIG. 10). The second grooves GRV2 may have a slit shape extending in a direction that intersects the edge BND of the main area MA.

In an embodiment, the second grooves GRV2 may be arranged to be directed parallel to the first grooves GRV1 having the slit shape on the first line LN1.

In an embodiment, like the first grooves GRV1 illustrated in FIGS. 16 and 17, each of the second grooves GRV2 may penetrate through at least a portion of the metal plate 200.

In an embodiment, when the second grooves GRV2 are formed in the first side area SS1, the second side area (SS2 in FIG. 10), the third side area (SS3 in FIG. 10), and the fourth side area (SS4 in FIG. 10), the compressive stress (FCMP in FIG. 11) for deformation into the double curvature area may also be distributed to the first side area SS1, the second side area (SS2 in FIG. 10), the third side area (SS3 in FIG. 10), and the fourth side area (SS4 in FIG. 10). As result, the buckling defect of the metal plate 200 may be further prevented.

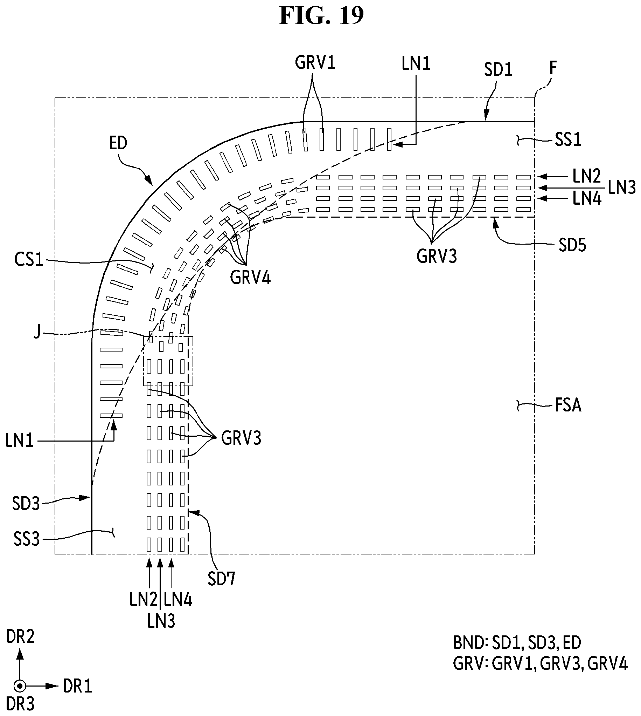

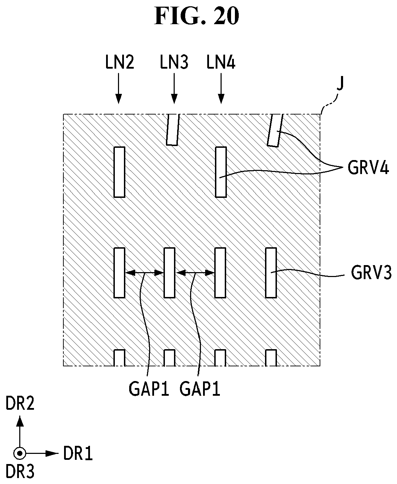

FIG. 19 is a plan view illustrating portion F of FIG. 10, according to another embodiment. FIG. 20 is an enlarged view illustrating portion J of FIG. 19, according to an embodiment.

Since the display device 10 according to an embodiment illustrated in FIG. 19 is substantially the same as the display device according to the embodiment of FIGS. 14 and 15, except that the plurality of grooves GRV further include third grooves GRV3 and fourth grooves GRV4, the redundant description will be omitted below.

In an embodiment and as illustrated in FIG. 19, the third grooves GRV3 may be formed in at least one of the first side area SS1, the second side area (SS2 in FIG. 10), the third side area (SS3 in FIG. 10), and the fourth side area (SS4 in FIG. 10), and may be disposed to be adjacent to the flat display area FSA.

In an embodiment, like the first grooves GRV1 illustrated in FIGS. 16 and 17, each of the third grooves GRV3 may penetrate through at least a portion of the metal plate 200.

In an embodiment and as illustrated in FIG. 19, the third grooves GRV3 may extend in a direction parallel to the edge BND of the main area MA.

That is, the third grooves GRV3 disposed in the first side area SS1 between the first side SD1 and the fifth side SD5 may have a slit shape extending in the first direction DR1 which is directed parallel to the first side SD1 and the fifth side SD5.

In an embodiment, on the other hand, the third grooves GRV3 disposed in the third side area SS3 between the third side SD3 and the seventh side SD7 may have a slit shape extending in the second direction DR2 to be directed parallel to the third side SD3 and the seventh side SD7.

In an embodiment, the third grooves GRV3 may be arranged on two or more of lines LN2, LN3, and LN4, where each of the two or more lines LN2, LN3, and LN4 may be directed parallel to the edge BND of the main area MA.

In an embodiment and as illustrated in FIG. 20, the two or more lines LN2, LN3, and LN4 may be spaced apart from each other by a first gap GAP1 in the direction intersecting the edge BND of the main area MA.

In an embodiment, the third grooves GRV3 have the same length and may be arranged at the same gap.

Accordingly, in an embodiment, the third grooves GRV3 of the two or more different lines LN2, LN3, and LN4 may face each other in the direction intersecting the edge BND of the main area MA.

In an embodiment, the two or more lines LN2, LN3, and LN4 may include a second line LN2, a third line LN3, and a fourth line LN4 sequentially arranged in a direction away from the edge BND of the main area MA. In this case, the third groove GRV3 of the second line LN2 may face the third groove GRV3 of the third line LN3 in the direction intersecting the edge BND of the main area MA, and the third groove GRV3 of the third line LN3 may face the third groove GRV3 of the fourth line LN4.

In an embodiment, the third grooves GRV3 may be further formed at an edge of the flat display area FSA. That is, the arrangement of the third grooves GRV3 may extend to a portion of the flat display area FSA disposed adjacent to the curved area CSA.

In an embodiment, the fourth grooves GRV4 may be formed in at least one of the first corner area CS1, the second corner area (CS2 in FIG. 10), the third corner area (CS3 in FIG. 10), and the fourth corner area (CS4 in FIG. 10), and may be disposed to be adjacent to the flat display area FSA.

In an embodiment, like the first grooves GRV1 illustrated in FIGS. 16 and 17, each of the fourth grooves GRV4 may penetrate through at least a portion of the metal plate 200.

In an embodiment, the fourth grooves GRV4 may extend in a direction parallel to the edge BND of the main area MA.

In an embodiment, the fourth groove GRV4 disposed in the first corner area CS1 may face a portion of the corner ED in contact with the first corner area CS1 in a direction perpendicular to or intersecting the edge BND of the main area MA, and may have a slit shape extending in a direction parallel to a portion of the corner ED.

According to an embodiment, the fourth grooves GRV4 may be arranged parallel to the third grooves GRV3 on the two or more lines LN2, LN3, and LN4.

In addition, in an embodiment, the fourth grooves GRV4 may be alternately arranged on the two or more lines LN2, LN3, and LN4.

That is, in an embodiment, the fourth groove GRV4 of the second line LN2 may face the fourth groove GRV4 of the fourth line LN4 in the direction intersecting the edge BND of the main area MA.

In an embodiment, the fourth grooves GRV4 may be further formed at an edge of the flat display area FSA. That is, the arrangement of the fourth grooves GRV4 may extend to a portion of the flat display area FSA disposed adjacent to the curved area CSA.

As described above, according to the embodiment of FIGS. 19 and 20, the repulsive force of the curved area CSA of the metal plate 200 may be reduced by the third grooves GRV3 and/or the fourth grooves GRV4. Accordingly, since the defect in which the metal plate 200 is restored to a flat shape may be reduced, the defect of air bubbles being inserted into the transparent adhesive layer 400 in the process of attaching the cover window 300 onto the display panel 100 may be reduced. Therefore, the display quality of the display device 10 may be improved.

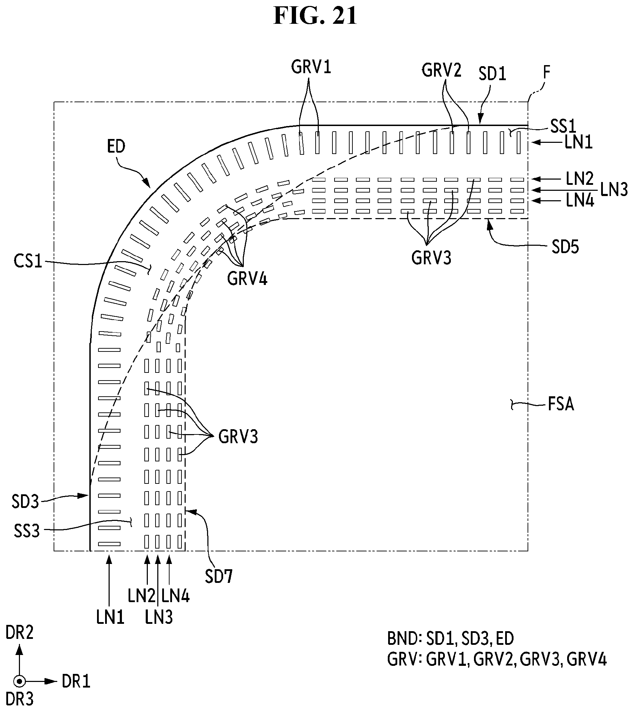

FIGS. 21, 22, 23, and 24 are plan views illustrating portion F of FIG. 10, according to embodiments.

Since the display device 10 according to an embodiment illustrated in FIG. 21 is substantially the same as the display device according to the embodiment of FIG. 20, except that the plurality of grooves GRV further include second grooves GRV2, the redundant description will be omitted below.

Additionally, since the second grooves GRV2 according to the embodiment of FIG. 21 are the same as those according to the embodiment illustrated in FIG. 18, the redundant description will be omitted below.

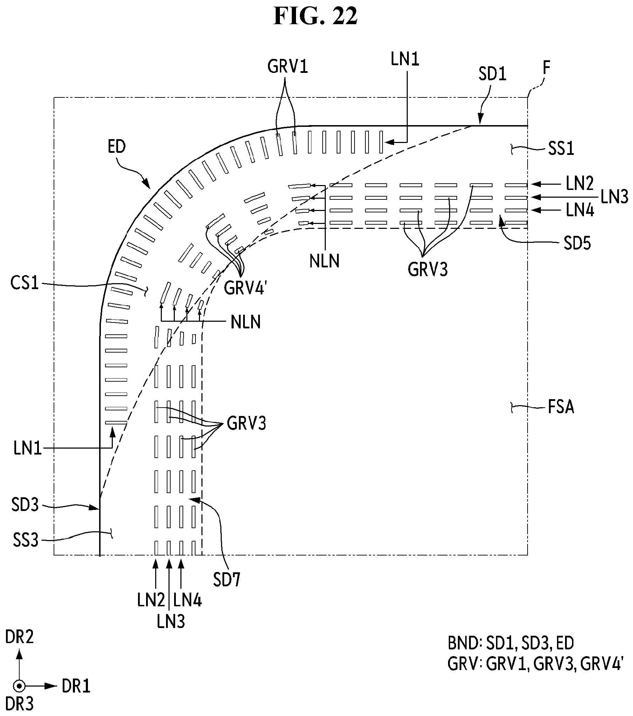

Moreover, since the display device 10 according to an embodiment illustrated in FIG. 22 is substantially the same as the display device 10 according to the embodiment of FIG. 10, except that fourth grooves GRV4' have a longer slit shape as being closer to the edge BND of the main area MA, the redundant description will be omitted below.

According to an embodiment of FIG. 22, the fourth grooves GRV4' formed in at least one of the first corner area CS1, the second corner area (CS2 in FIG. 10), the third corner area (CS3 in FIG. 10), and the fourth corner area (CS4 in FIG. 10) may be disposed in a slit shape with a longer length as being closer to the corner ED of the edge BND of the main area MA, and may be disposed in a slit shape with a shorter length as being closer to the flat display area FSA.

In an embodiment, in each of the first corner area CS1, the second corner area (CS2 in FIG. 10), the third corner area (CS3 in FIG. 10), and the fourth corner area (CS4 in FIG. 10), the compressive stress (FCMP in FIG. 11) for deformation into the double curvature area may be more significantly generated as being closer to the corner ED of the edge BND of the main area MA.

However, according to an embodiment of FIG. 22, as the fourth grooves GRV4' are disposed in the slit shape with the longer length as being closer to the corner ED of the edge BND of the main area MA, a difference in compressive stress (FCMP in FIG. 11) may be compensated. As a result, the buckling defect of the metal plate 200 may be further prevented and thereby display quality improved.

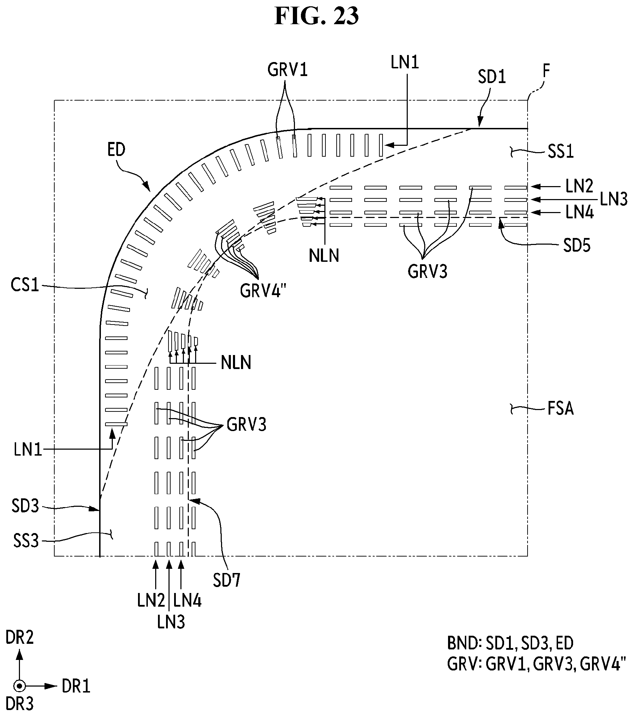

Since the display device 10 according to an embodiment illustrated in FIG. 23 is substantially the same as the display device according to the embodiment of FIG. 22, except that fourth grooves GRV4" are arranged on separate narrow lines NLN, the redundant description will be omitted below.

In an embodiment, each of the two or more narrow lines NLN may be parallel to the edge BND of the main area MA.

Unlike the two or more lines LN2, LN3, and LN4 on which the third grooves GRV3 are arranged, which are spaced apart from each other by the first gap (GAP1 in FIG. 20) or more, in an embodiment, the two or more narrow lines NLN may be spaced apart from each other by a second gap or less that is smaller than the first gap GAP1.

In an embodiment, the fourth grooves GRV4" arranged on the two or more narrow lines NLN may have a slit shape of a longer length as being closer to the edge BND of the main area MA.

That is, when the two or more narrow lines NLN include a first narrow line adjacent to the edge BND of the main area MA and a second narrow line adjacent to the edge of the flat display area FSA, the fourth groove GRV4" of the second narrow line may have a shorter length than the fourth groove GRV4" of the first narrow line.

In an embodiment, the force (FCMP in FIG. 11) applied to the first corner area CS1, the second corner area (CS2 in FIG. 10), the third corner area (CS3 in FIG. 10), and the fourth corner area (CS4 in FIG. 10) that are deformed into the double curvature shape may be strongly concentrated compared to the force (FBND in FIG. 11) applied to the first side area SS1, the second side area (SS2 in FIG. 10), the third side area SS3, and the fourth side area (SS4 in FIG. 10) that are bent in a single curvature. Accordingly, the repulsive force in the first corner area CS1, the second corner area (CS2 in FIG. 10), the third corner area (CS3 in FIG. 10), and the fourth corner area (CS4 in FIG. 10) may be greater than that in the first side area SS1, the second side area (SS2 in FIG. 10), the third side area SS3, and the fourth side area (SS4 in FIG. 10).

Accordingly, as in an embodiment of FIG. 23, when the fourth grooves GRV4" disposed in the first corner area CS1, the second corner area (CS2 in FIG. 10), the third corner area (CS3 in FIG. 10), and the fourth corner area (CS4 in FIG. 10) are arranged at a narrower gap than the third grooves GRV3 in the direction intersecting the edge BND of the main area MA, the amount of reduction in the repulsive force by the fourth grooves GRV4" may be greater than the amount of reduction in the repulsive force by the third grooves GRV3.

As a result, the restoration defect in the first corner area CS1, the second corner area (CS2 in FIG. 10), the third corner area (CS3 in FIG. 10), and the fourth corner area (CS4 in FIG. 10) may be further reduced thereby improving display quality.

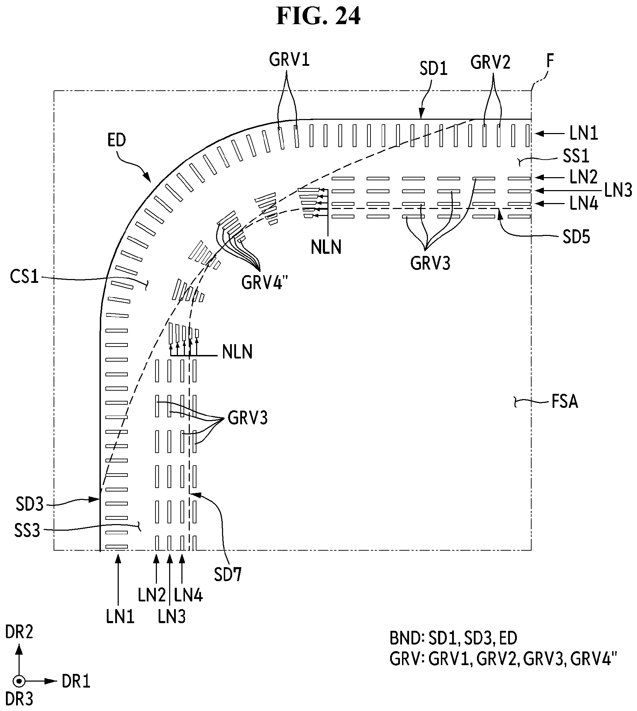

Since the display device 10 according to an embodiment illustrated in FIG. 24 is substantially the same as the display device according to the embodiment of FIG. 23, except that the plurality of grooves GRV further include second grooves GRV2, the redundant description will be omitted below.

Additionally, since the second grooves GRV2 according to the embodiment of FIG. 24 are the same as those according to the embodiment illustrated in FIG. 18, the redundant description will be omitted below.

As illustrated in Table 1 below, as a result of simulating a buckling index in the double curvature area, according to the embodiments illustrated in FIGS. 19, 21, 22, 23, and 24, together with a comparative example in which the metal plate 200 does not include the groove GRV, it may be confirmed that the buckling index of the comparative example is about 224.85, which exceeds 200, while the buckling index of the embodiments is less than about 100.

In addition, it may also be confirmed that the buckling index of the embodiments that do not include the second groove GRV2 as illustrated in FIGS. 19 and 23 exceeds about 30, while the buckling index of the embodiments including the second groove GRV2 as illustrated in FIGS. 21 and 24 is less than about 30.

**[Table 1]**

| Simulation Target | Simulation Result of Buckling Index |
|---|---|
| Comparative Example | 224.85 |
| Embodiment of FIG. 22 | 52.9 |
| Embodiment of FIG. 19 | 39.73 |
| Embodiment of FIG. 23 | 45.69 |
| Embodiment of FIG. 21 | 24.72 |
| Embodiment of FIG. 24 | 14.14 |

The display device according to one embodiment of the present disclosure can be applied to various electronic devices. The electronic device according to the one embodiment of the present disclosure includes the display device described above, and may further include modules or devices having additional functions in addition to the display device.

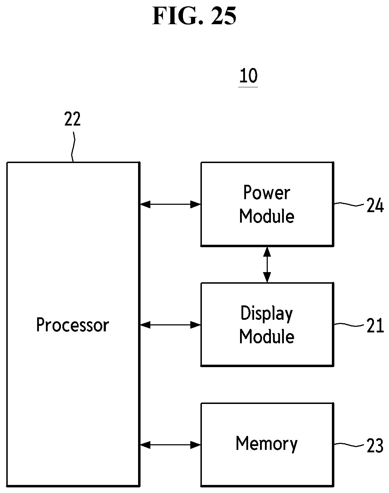

FIG. 25 is a block diagram of an electronic device according to an embodiment of the present disclosure.

Referring to FIG. 25, the electronic device 1 according to one embodiment of the present disclosure may include a display module 21, a processor 22, a memory 23, and a power module 24.

The processor 22 may include at least one of a central processing unit (CPU), an application processor (AP), a graphic processing unit (GPU), a communication processor (CP), an image signal processor (ISP), and a controller.

The memory 23 may store data information necessary for the operation of the processor 22 or the display module 21. When the processor 22 executes an application stored in the memory 23, an image data signal and/or an input control signal is transmitted to the display module 21, and the display module 21 can process the received signal and output image information through a display screen.

The power module 24 may include a power supply module such as, for example a power adapter or a battery, and a power conversion module that converts the power supplied by the power supply module to generate power necessary for the operation of the electronic device 1.

At least one of the components of the electronic device 10 according to the one embodiment of the present disclosure may be included in the display device 100 according to the embodiments of the present disclosure. In addition, some modules of the individual modules functionally included in one module may be included in the display device 100, and other modules may be provided separately from the display device 100. For example, the display device 100 may include the display module 21, and the processor 22, the memory 23, and the power module 24 may be provided in the form of other devices within the electronic device 10 other than the display device 100.

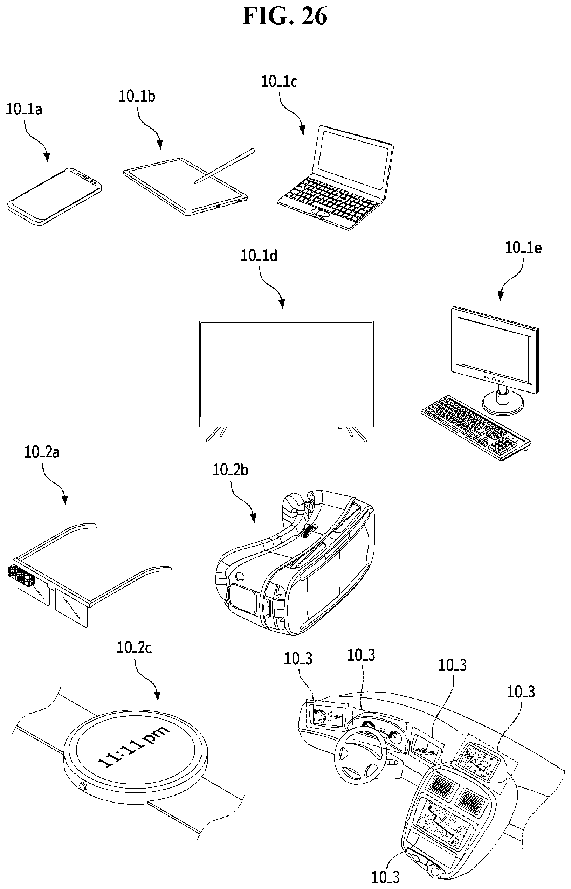

FIG. 26 is a schematic diagram of an electronic device according to various embodiments of the present disclosure.

Referring to FIG. 26, various electronic devices to which display devices 100 according to embodiments of the present disclosure are applied may include not only image display electronic devices such as a smart phone 10_1a, a tablet PC (personal computer) 10_1b, a laptop 10_1c, a TV 10_1d, and a desk monitor 10_1e, but also wearable electronic devices including display modules such as, for example smart glasses 10_2a, a head mounted display 10_2b, and a smart watch 10_2c, and vehicle electronic devices 10_3 including display modules such as a CID (Center Information Display) and a room mirror display arranged on a dashboard, center fascia, and dashboard of an automobile.

However, the effects of the invention are not restricted to the embodiments set forth herein. The above and other effects of the invention will become more apparent to one of ordinary skill in the art to which the invention pertains. Thus, it will be understood by one of ordinary skill in the art to which the invention belongs that the invention may be implemented in other specific embodiments than those described herein without changing the essential features of the invention. Therefore, it is to be understood that the exemplary embodiments described above are illustrative rather than being restrictive in all aspects. The disclosed embodiments of the invention are used in a generic and descriptive sense only and not for purposes of limitation. Each component specifically shown in the embodiments of the invention can be implemented by modification, and such modifications and differences related to invention should be construed as being included in the scope of the invention. Moreover, the embodiments or parts of the embodiments may be combined in whole or in part without departing from the scope of the invention.

## Claims

1. A display device (10) comprising:
a display panel (100) configured to emit light for displaying an image;
a metal plate (200) disposed under the display panel (100) and supporting the display panel (100);
wherein the display panel (100) includes a substrate (110), a circuit layer (120) disposed on the substrate (110) and an element layer (130) disposed on the circuit layer (120),
wherein the substrate (110) includes a main area (MA) including a flat display area (FSA) having a flat shape and a curved area (CSA) having a curved shape disposed around the flat display area (FSA),
wherein the curved area (CSA) includes a peripheral display area (PSA) disposed around the flat display area (FSA), and a non-display area (NDA) disposed between an edge (BND) of the main area (MA) and the peripheral display area (PSA),
wherein light emitting areas (EA) are disposed in the flat display area (FSA) and the peripheral display area (PSA),
wherein the element layer (130) includes light emitting elements (LE) disposed in the light emitting areas (EA), and
a plurality of grooves (GRV) formed in at least a portion of an edge of the metal plate (200) and penetrating through at least a portion of the metal plate (200).

2. The display device (10) of claim 1, wherein the metal plate (200) includes the main area (MA),
wherein the edge (BND) of the main area (MA) includes:
a first side (SD1) and a second side (SD2) extending in a first direction (DR1) and opposing each other in a second direction (DR2) intersecting the first direction (DR1);
a third side (SD3) and a fourth side (SD4) extending in the second direction (DR2) and opposing each other in the first direction (DR1); and
corners (ED) connecting one of the first side (SD1) and the second side (SD2) and one of the third side (SD3) and the fourth side (SD4), wherein
the plurality of grooves (GRV) include first grooves (GRV1, GRV1') that are formed in a portion of the curved area (CSA), disposed adjacent to at least one of the corners (ED), and spaced apart from the edge (BND) of the main area (MA).

3. The display device (10) of claim 2, wherein the flat display area (FSA) includes:
a fifth side (SD5) and a sixth side (SD6) extending in the first direction (DR1) and opposing each other in the second direction (DR2); and
a seventh side (SD7) and an eighth side (SD8) extending in the second direction (DR2) and opposing each other in the first direction (DR1),
wherein the curved area (CSA) includes:
a first side area (SS1) disposed between the first side (SD1) and the fifth side (SD5);
a second side area (SS2) disposed between the second side (SD2) and the sixth side (SD6);
a third side area (SS3) disposed between the third side (SD3) and the seventh side (SD7;
a fourth side area (SS4) disposed between the fourth side (SD4) and the eighth side (SD8);
a first corner area (CS1) in contact with a vertex between the fifth side (SD5) and the seventh side (SD7) and disposed between the first side area (SS1) and the third side area (SS3);
a second corner area (CS2) in contact with a vertex between the sixth side (SD6) and the seventh side (SD7) and disposed between the second side area (SS2) and the third side area (SS3);
a third corner area (CS3) in contact with a vertex between the sixth side (SD6) and the eighth side (SD8) and disposed between the second side area (SS2) and the fourth side area (SS4); and
a fourth corner area (CS4) in contact with a vertex between the fifth side (SD5) and the eighth side (SD8) and disposed between the first side area (SS1) and the fourth side area (SS4), wherein
the first grooves (GRV1, GRV1') are formed in at least one of the first corner area (CS1), the second corner area (CS2), the third corner area (CS3), and the fourth corner area (CS4).

4. The display device (10) of claim 3, wherein the first grooves (GRV1, GRV1') are further arranged in a portion of at least one of the first side area (SS1), the second side area (SS2), the third side area (SS3), and the fourth side area (SS4).

5. The display device (10) of any one of the preceding claims 3 to 4, wherein the first grooves (GRV1') have a polygonal or circular shape and are arranged to be directed parallel in directions (DR1, DR2) intersecting each other.

6. The display device (10) of any one of the preceding claims 3 to 4, wherein the first grooves (GRV1) have a slit shape extending in a direction intersecting the edge (BND) of the main area (MA), and/or
the first grooves (GRV1) are arranged in a first line (LN1) which is directed parallel to the edge (BND) of the main area (MA).

7. The display device (10) of claim 6, wherein the plurality of grooves (GRV) further include:
second grooves (GRV2) formed in at least one of the first side area (SS1), the second side area (SS2), the third side area (SS3), and the fourth side area (SS4) and having a slit shape extending in the direction intersecting the edge (BND) of the main area (MA), wherein
the second grooves (GRV2) are arranged to be directed parallel with the first grooves (GRV1) in the first line (LN1).

8. The display device (10) of any one of the preceding claims 6 to 7, wherein the plurality of grooves (GRV) further include:
third grooves (GRV3) formed in at least one of the first side area (SS1), the second side area (SS2), the third side area (SS3), and the fourth side area (SS4), wherein the third grooves (GRV3) are disposed adjacent to the flat display area (FSA); and/or
fourth grooves (GRV4) formed in at least one of the first corner area (CS1), the second corner area (CS2), the third corner area (CS3), and the fourth corner area (CS4), wherein the fourth grooves (GRV4) are disposed adjacent to the flat display area (FSA), wherein
the third grooves (GRV3) and the fourth grooves (GRV4) have a slit shape extending in a direction parallel to the edge (BND) of the main area (MA).

9. The display device (10) of claim 8, wherein at least some of the third grooves (GRV3) and the fourth grooves (GRV4) are formed at an edge of the flat display area (FSA).

10. The display device (10) of any one of the preceding claims 8 to 9, wherein the third grooves (GRV3) are arranged in two or more lines (LN2, LN3, LN4), wherein
each of the two or more lines (LN2, LN3, LN4) are directed parallel to the edge (BND) of the main area (MA), and
the two or more lines (LN2, LN3, LN4) are spaced apart from each other by a first gap (GAP1) in the direction intersecting the edge (BND) of the main area (MA).

11. The display device (10) of claim 10, wherein the two or more lines (LN2, LN3, LN4) include a second line (LN2) and a third line (LN3), and
in a direction intersecting the edge (BND) of the main area (MA), a third groove (GRV3) of the second line (LN2) faces a third groove (GRV3) of the third line (LN3).

12. The display device (10) of claim 11, wherein the fourth grooves (GRV4) are arranged to be directed parallel to third grooves (GRV3) in the two or more lines (LN2, LN3, LN4).

13. The display device (10) of claim 12, wherein the two or more lines (LN2, LN3, LN4) further include a fourth line (LN4),
wherein the third line (LN3) is disposed between the second line (LN2) and the fourth line (LN4), and
wherein, in the direction intersecting the edge (BND) of the main area (MA), a fourth groove (GRV4') of the second line (LN2) faces a fourth groove (GRV4) of the fourth line (LN4).

14. The display device (10) of any of the preceding claims 10 to 13, wherein the fourth grooves (GRV4") are arranged in two or more narrow lines (NLN),
where in each of the two or more narrow lines (NLN) are directed parallel to the edge (BND) of the main area (MA), and
wherein the two or more narrow lines (NLN) are spaced apart from each other by a second gap, which is smaller than the first gap (GAP1), in the direction intersecting the edge (BND) of the main area (MA), and/or,
wherein the two or more narrow lines (NLN) include a first narrow line disposed adjacent to the edge (BND) of the main area (MA), and a second narrow line disposed adjacent to an edge (BND) of the flat display area (FSA), and
wherein the fourth groove (GRV4") of the second narrow line has a shorter length than the fourth groove (GRV) of the first narrow line.

15. An electronic device comprising a display device according to any of the preceding claims 1 to 14.
